# EUROPÄISCHE PATENTSCHRIFT

(11) **EP 4 702 357 B1**
(45) Veröffentlichungstag und Bekanntmachung des Hinweises auf die Patenterteilung: **08.07.2026**
(21) Anmeldenummer: 24729199.0
(22) Anmeldetag: 22.05.2024
(51) Int. Cl.: G01R 1/20, H01C 1/14, H01C 7/00, H01C 7/06

(54) **STROMMESSWIDERSTAND, STROMMESSSCHALTUNG UND ZUGEHÖRIGES BETRIEBSVERFAHREN UND HERSTELLUNGSVERFAHREN**
CURRENT-MEASURING RESISTOR, CURRENT-MEASURING CIRCUIT, AND ASSOCIATED OPERATING METHOD AND PRODUCTION METHOD
RÉSISTANCE DE MESURE DE COURANT, CIRCUIT DE MESURE DE COURANT ET PROCÉDÉ DE FONCTIONNEMENT ET PROCÉDÉ DE PRODUCTION ASSOCIÉS

(30) Priorität: 24.07.2023 DE 102023119527
(43) Veröffentlichungstag der Anmeldung: 04.03.2026
(73) Patentinhaber: Isabellenhütte Heusler GmbH & Co. KG, 35683 Dillenburg (DE)
(72) Erfinder: LEBEAU, Felix, 35745 Herborn (DE); KRAMM, Benedikt, 35435 Wettenberg (DE); DIETERMANN, Manuel, 35708 Haiger (DE); SATTLER, Jan, 35708 Haiger (DE)
(74) Vertreter: v. Bezold & Partner Patentanwälte - PartG mbB
(86) Internationale Anmeldenummer: PCT/EP2024/064096
(87) Internationale Veröffentlichungsnummer: WO 2025/021343

(56) Entgegenhaltungen:
- EP-A1- 3 851 859
- WO-A1-2021/014872
- DE-A1- 102019 218 308
- US-A1- 2017 089 955

## Beschreibung

### Technisches Gebiet der Erfindung

Die Erfindung betrifft einen niederohmigen Strommesswiderstand ("Shunt") zur Messung eines elektrischen Stroms. Weiterhin betrifft die Erfindung eine Strommessschaltung mit einem solchen Strommesswiderstand. Darüber hinaus umfasst die Erfindung auch ein Betriebsverfahren für eine solche Strommessschaltung und ein Herstellungsverfahren für den erfindungsgemäßen Strommesswiderstand.

### Hintergrund der Erfindung

Es ist aus dem Stand der Technik (z.B. EP 0 605 800 A1) bekannt, einen elektrischen Strom mittels eines niederohmigen Strommesswiderstands ("Shunt") gemäß der sogenannten Vierleitertechnik zu messen. Dabei wird der zu messende elektrische Strom über zwei Leiter durch den niederohmigen Strommesswiderstand geleitet, wobei mittels zweier weiterer Leiter die Spannung über dem niederohmigen Strommesswiderstand gemessen wird. Entsprechend dem Ohmschen Gesetz ist die gemessene Spannung über dem Strommesswiderstand dann ein Maß für den Strom, der durch den niederohmigen Strommesswiderstand fließt.

Aus EP 3 851 859 A1 ist eine Abwandlung eines solchen niederohmigen Strommesswiderstands bekannt, der zwischen den beiden Anschlussteilen zum Einleiten bzw. Ausleiten des elektrischen Stroms nicht nur ein einziges Widerstandselement aufweist, sondern zwei Widerstandselemente, die zwischen den beiden Anschlussteilen in Reihe geschaltet sind und beide von dem elektrischen Strom durchflossen werden. Zwischen den beiden Widerstandselementen ist hierbei ein Zwischenelement angeordnet, das aus einem Leitermaterial besteht, was einen Spannungsabgriff an dem Zwischenelement ermöglicht.

Nachteilig an diesem bekannten Strommesswiderstand ist der relativ hohe Herstellungsaufwand, da das zusätzliche Zwischenelement mit den beiden angrenzenden Widerstandselementen verbunden werden muss.

Zum allgemeinen technischen Hintergrund der Erfindung ist auch hinzuweisen auf DE 10 2020 111 634 B3, WO 2021/014872 A1, US 2017/089955 A1, DE 10 2019 218 308 A1 und DE 10 2004 051 472 A1. Diese Druckschriften offenbaren lediglich herkömmliche Strommesswiderstände mit einem einzigen Widerstandselement.

Schließlich offenbart EP 3 851 859 A1 einen Strommesswiderstand gemäß dem Oberbegriff von Anspruch 1. Dieser bekannte Strommesswiderstand löst jedoch die vorstehend beschriebenen Probleme nicht.

### Beschreibung der Erfindung

Der Erfindung liegt deshalb die Aufgabe zugrunde, den vorstehend beschriebenen bekannten Strommesswiderstand mit zwei Widerstandselementen zu verbessern. Weiterhin liegt der Erfindung die Aufgabe zugrunde, ein Herstellungsverfahren für einen solchen verbesserten Strommesswiderstand und ein Betriebsverfahren dafür anzugeben.

Diese Aufgabe wird durch einen erfindungsgemäßen Strommesswiderstand, ein zugehöriges Betriebsverfahren und ein entsprechendes Herstellungsverfahren gemäß den unabhängigen Ansprüchen gelöst.

Der erfindungsgemäße Strommesswiderstand weist zunächst in Übereinstimmung mit dem eingangs beschriebenen bekannten Strommesswiderstand zwei Anschlussteile aus einem Leitermaterial (z.B. Kupfer) auf, um den zu messenden elektrischen Strom in den Strommesswiderstand einzuleiten bzw. aus dem Strommesswiderstand auszuleiten.

Beispielweise kann es sich bei dem Leitermaterial der Anschlussteile um Kupfer, eine Kupferlegierung, Aluminium oder eine Aluminiumlegierung handeln, jedoch ist die Erfindung hinsichtlich des Leitermaterials nicht auf diese Materialbeispiele beschränkt.

Hierbei ist zu erwähnen, dass die beiden Anschlussteile vorzugsweise aus demselben Leitermaterial bestehen. Es besteht jedoch alternativ auch die Möglichkeit, dass die beiden Anschlussteile aus unterschiedlichen Leitermaterialien bestehen, beispielsweise aus Kupfer oder einer Kupferlegierung auf einer Seite und aus Aluminium oder einer Aluminiumlegierung auf der gegenüberliegenden Seite.

Darüber hinaus weist auch der erfindungsgemäße Strommesswiderstand in Übereinstimmung mit dem vorstehend beschriebenen bekannten Strommesswiderstand gemäß EP 3 851 859 A1 zwei Widerstandselemente auf, die in Stromflussrichtung zwischen den beiden Anschlussteilen angeordnet und elektrisch in Reihe geschaltet sind, so dass der zu messende elektrische Strom im Betrieb durch die beiden Widerstandselemente fließt.

Im Gegensatz zu dem vorstehend beschriebenen bekannten Strommesswiderstand gemäß EP 3 851 859 A1 ist bei dem erfindungsgemäßen Stromesswiderstand jedoch zwischen den beiden Widerstandselementen kein Zwischenelement angeordnet. Stattdessen sind die beiden Widerstandselemente bei dem erfindungsgemäßen Strommesswiderstand elektrisch und mechanisch direkt und unmittelbar miteinander verbunden, beispielsweise durch eine Schweißnaht. Dies bietet den Vorteil, dass die Herstellung des erfindungsgemäßen Strommesswiderstands deutlich einfacher und kostengünstiger ist, da kein Zwischenelement benötigt wird und somit auf eine Verbindung (z.B. Schweißnaht) verzichtet werden kann. Die Erfindung überwindet dabei das Vorurteil gemäß EP 3 851 859 A1, wonach zur Positionierung eines Spannungsabgriffs zwischen den beiden Widerstandselementen ein separates Zwischenelement aus einem Leitermaterial erforderlich ist.

Dennoch bietet auch der erfindungsgemäße Strommesswiderstand den Vorteil, dass die beiden Widerstandselemente unterschiedliche Eigenschaften haben können, wodurch sogenannte Common Cause Failures (CCF) vermieden werden können.

Zur Vermeidung von Common Cause Failures unterscheiden sich die beiden Widerstandselemente vorzugsweise hinsichtlich des spezifischen elektrischen Widerstands, hinsichtlich der Langzeitdrift des spezifischen elektrischen Widerstands, hinsichtlich des Temperaturkoeffizienten des spezifischen elektrischen Widerstands und/oder hinsichtlich der Produktions-Charge. Die beiden Widerstandselemente können also aus unterschiedlichen Produktions-Chargen stammen, so dass eine fehlerhafte Produktions-Charge im Betrieb des Stromesswiderstands erkannt werden kann.

Darüber hinaus können die beiden Widerstandselemente auch unterschiedliche Widerstandswerte haben.

Weiterhin besteht im Rahmen der Erfindung die Möglichkeit, dass das erste Widerstandselement und das zweite Widerstandselement unterschiedliche Widerstandswerte haben, aber aus demselben Widerstandsmaterial bestehen. Dies kann insbesondere dann vorteilhaft sein, wenn der Strommesswiderstand in der Aufsicht L-förmig ist, wie nachstehend noch detailliert beschrieben wird.

In einem bevorzugten Ausführungsbeispiel der Erfindung sind die Anschlussteile und die Widerstandselemente des erfindungsgemäßen Strommesswiderstands jeweils plattenförmig. Hierbei können die Anschlussteile und die Widerstandselemente jeweils mit ihren Seitenkanten direkt aneinander anstoßen oder planparallel überlappen. Dies gilt für die Verbindung zwischen dem ersten Anschlussteil und dem ersten Widerstandselement, für die Verbindung zwischen den beiden Widerstandselementen und auch für die Verbindung zwischen dem zweiten Widerstandselement und dem zweiten Anschlussteil.

Bei einer überlappenden Verbindung zwischen den plattenförmigen Widerstandselementen und den plattenförmigen Anschlussteilen bestehen wiederum verschiedene Möglichkeiten der technischen Realisierung.

In einer Variante der Erfindung liegt das erste Anschlussteil planparallel überlappend auf der Oberseite des ersten Widerstandselements auf. Es ist jedoch umgekehrt auch möglich, dass das erste Widerstandselement planparallel überlappend auf der Oberseite des ersten Anschlussteils aufliegt.

Weiterhin besteht die Möglichkeit, dass das erste Widerstandselement planparallel überlappend auf der Oberseite des zweiten Widerstandselements aufliegt. Es besteht jedoch umgekehrt auch die Möglichkeit, dass das zweite Widerstandselement planparallel überlappend auf der Oberseite des ersten Widerstandselements aufliegt.

Darüber hinaus besteht im Rahmen der Erfindung die Möglichkeit, dass das zweite Widerstandselement planparallel überlappend auf der Oberseite des zweiten Anschlussteils aufliegt. Es besteht jedoch umgekehrt auch die Möglichkeit, dass das zweite Anschlussteil planparallel überlappend auf der Oberseite des zweiten Widerstandselements aufliegt.

Die Begriffe Oberseite und Unterseite bzw. oben und unten beziehen sich hierbei vorzugsweise auf die Montage des Strommesswiderstands auf einer Leiterplatte und/oder einer Busbar. Dies bedeutet, dass die Oberseite des Strommesswiderstands die der Leiterplatte abgewandte Seite des Strommesswiderstands ist, während die Unterseite des Strommesswiderstands die der Leiterplatte zugewandte Seite des Strommesswiderstands ist.

Hinsichtlich der elektrischen und mechanischen Verbindung zwischen den verschiedenen Komponenten (Anschlussteile und Widerstandselemente) bestehen im Rahmen der Erfindung verschiedene Möglichkeiten, von denen einige nachfolgend kurz beschrieben werden.

So kann diese Verbindung eine Schweißverbindung sein, beispielsweise eine Elektronenstrahlschweißverbindung, eine Laserschweißverbindung, eine Widerstandsschweißverbindung oder eine Punktschweißverbindung. Eine solche Punktschweißverbindung ist beispielsweise aus der deutschen Patentanmeldung DE 10 2022 109 709.9 bekannt, so dass der Inhalt dieser früheren Patentanmeldung der vorliegenden Beschreibung in vollem Umfang zuzurechnen ist.

Es besteht jedoch alternativ auch die Möglichkeit, dass es sich bei der Verbindung zwischen den verschiedenen Komponenten (Anschlussteile und Widerstandselemente) um eine Pressverbindung handelt, insbesondere um eine Press-Sinter-Verbindung. Eine solche Press-Sinter-Verbindung ist beispielsweise aus der deutschen Patentanmeldung DE 10 2022 109 708.0 bekannt, so dass der Inhalt dieser früheren Patentanmeldung der vorliegenden Beschreibung in vollem Umfang zuzurechnen ist.

Ferner besteht auch die Möglichkeit, dass es sich bei der Verbindung zwischen den verschiedenen Komponenten (Anschlussteile und Widerstandselemente) um eine Lötverbindung handelt, beispielsweise eine Hartlötverbindung oder eine Weichlötverbindung.

Die Erfindung ist jedoch hinsichtlich der Verbindung der einzelnen Komponenten (Anschlussteile und Widerstandselemente) des Strommesswiderstands nicht auf die vorstehend beschriebenen Beispiele beschränkt, sondern grundsätzlich auch mit anderen Fügeverfahren realisierbar.

Darüber hinaus ist allgemein zu erwähnen, dass die beiden Widerstandselemente in Stromflussrichtung die gleiche Länge haben können. Es besteht jedoch alternativ auch die Möglichkeit, dass die beiden Widerstandselemente in Stromflussrichtung eine unterschiedliche Länge haben.

Ferner ist allgemein zu erwähnen, dass die beiden Widerstandselemente quer zur Stromflussrichtung die gleiche Breite haben können. Es besteht jedoch alternativ auch die Möglichkeit, dass die beiden Widerstandselemente quer zur Stromflussrichtung eine unterschiedliche Breite haben.

Weiterhin ist allgemein zu erwähnen, dass die beiden Widerstandselemente bei einer plattenförmigen Gestaltung wahlweise die gleiche Dicke oder unterschiedliche Dicken haben können.

Zur Strommessung gemäß der bekannten Vierleitertechnik weist der erfindungsgemäße Strommesswiderstand vorzugsweise mehrere Spannungsabgriffe auf, um an dem Strommesswiderstand an verschiedenen Stellen das elektrische Potenzial zu messen. So befindet sich an dem ersten Anschlussteil vorzugsweise ein erster Spannungsabgriff. Darüber hinaus weist der erfindungsgemäße Strommesswiderstand vorzugsweise einen zweiten Spannungsabgriff auf, der vorzugsweise einen realen oder virtuellen Mittelabgriff an dem Strommesswiderstand zwischen den beiden Anschlussteilen ermöglicht. Der zweite Spannungsabgriff ist deshalb vorzugsweise an dem ersten Widerstandselement, an dem zweiten Widerstandselement oder an der Verbindung (z.B. Schweißnaht) zwischen den beiden Widerstandselementen angeordnet, um einen realen Mittelabgriff zu ermöglichen. Es besteht jedoch alternativ auch die Möglichkeit, dass der zweite Spannungsabgriff an dem ersten Anschlussteil oder an dem zweiten Anschlussteil angeordnet ist und dann einen virtuellen Mittelabgriff bildet, wobei dann vorzugsweise sogenannte Stromschatten vorgesehen sind, damit das elektrische Potenzial an dem zweiten Spannungsabgriff dem elektrischen Potenzial in der Mitte entspricht. Die Idee eines virtuellen Mittelabgriffs ist beispielsweise auch aus DE 10 2020 111 634 B3 und aus 10 2021 103 238 A1 bekannt, so dass der Inhalt dieser beiden früheren Patentveröffentlichungen der vorliegenden Beschreibung in vollem Umfang zuzurechnen ist.

Darüber hinaus weist der erfindungsgemäße Strommesswiderstand vorzugsweise einen dritten Spannungsabgriff an dem zweiten Anschlussteil auf. Bei drei Spannungsabgriffen an dem Strommesswiderstand können die Spannungsabgriffe mehrere Messkanäle bilden, nämlich einen ersten Messkanal für eine Spannungsmessung zwischen dem ersten Spannungsabgriff und dem zweiten Spannungsabgriff, einen zweiten Messkanal zur Spannungsmessung zwischen dem zweiten Spannungsabgriff und dem dritten Spannungsabgriff und einen dritten Messkanal zur Spannungsmessung zwischen dem ersten Spannungsabgriff und dem dritten Spannungsabgriff.

Bei der vorstehend erwähnten Erfindungsvariante mit einem virtuellen Mittelabgriff kann der zweite Spannungsabgriff wahlweise an dem ersten Anschlussteil oder an dem zweiten Anschlussteil angeordnet sein. In beiden Fällen sollte der zweite Spannungsabgriff hierbei mindestens teilweise von einem ersten Schlitz umgeben sein, der einen Stromfluss quer über den ersten Schlitz verhindert. Ein derartiger Schlitz wird in der üblichen Fachsprache auch als Stromschatten bezeichnet, was an sich aus dem Stand der Technik bekannt ist. Der Stromschatten verformt hierbei die Potenziallinien innerhalb des Strommesswiderstands so, dass am Ort des zweiten Spannungsabgriffs annähernd dasselbe elektrische Potenzial gemessen wird wie in der Mitte zwischen den Anschlussteilen am Ort eines realen Mittelabgriffs.

Bei der Erfindungsvariante mit dem vorstehend beschriebenen virtuellen Mittelabgriff besteht auch die Möglichkeit, dass auch der dritte Spannungsabgriff an dem zweiten Anschlussteil von einem Schlitz (Stromschatten) bogenförmig umgeben ist. Darüber hinaus kann hierbei optional ein vierter Spannungsabgriff vorgesehen sein, der ebenfalls an dem zweiten Anschlussteil angreift.

Die beiden vorstehend erwähnten Stromschatten (Schlitze) können wahlweise an derselben Längsseitenkante des Strommesswiderstands angeordnet sein oder an gegenüberliegenden Längsseitenkanten des Strommesswiderstands.

Weiterhin ist zu erwähnen, dass sich der mindestens eine Stromschatten (Schlitz) vorzugsweise von einer Längsseitenkante des jeweiligen Anschlussteils ausgehend bogenförmig (z.B. L-förmig oder C-förmig) um den jeweiligen Spannungsabgriff erstreckt und zwar vorzugsweise bis in das angrenzende Widerstandselement hinein. Dadurch wird in dem jeweiligen Anschlussteil eine Kontaktinsel abgetrennt, so dass der Strom zwingend über das angrenzende Widerstandselement fließen muss. Es besteht jedoch alternativ auch die Möglichkeit, dass der jeweilige Stromschatten nur bis zu der Grenze zu dem Widerstandselement ragt oder bereits vor der Grenze zu dem jeweiligen Widerstandselement endet.

Ferner ist zu erwähnen, dass die einzelnen Stromschatten (Schlitze) vorzugsweise bogenförmig sind, beispielsweise C-förmig oder L-förmig, wobei die Stromschatten (Schlitze) dabei mit ihren Enden vorzugsweise den Widerstandselementen zugewandt sind.

Es wurde vorstehend bereits erwähnt, dass die beiden Widerstandselemente vorzugsweise plattenförmig sind, wie auch die beiden Anschlussteile vorzugsweise plattenförmig sind. Hierbei besteht die Möglichkeit, dass der Strommesswiderstand als Ganzes L-förmig ist. Das erste Widerstandselement ist hierbei an einer ersten Seitenkante des zweiten Widerstandselements angebracht, so dass sich das zweite Widerstandselement in einer Aufsicht im Wesentlichen rechtwinklig zu dem ersten Widerstandselement erstreckt. Der Strommesswiderstand weist hierbei also zwei Schenkel auf, wobei der erste Schenkel vorzugsweise das erste Anschlussteil und das erste Widerstandselement enthält, während der zweite Schenkel vorzugsweise das zweite Widerstandselement und das zweite Anschlussteil enthält. An einer zweiten Seitenkante des zweiten Widerstandselements kann dann ein plattenförmiges drittes Anschlussteil aus einem Leitermaterial (z.B. Kupfer) angebracht sein, beispielsweise durch eine Schweißverbindung. An diesem dritten Anschlussteil kann dann der dritte Spannungsabgriff an dem plattenförmigen dritten Anschlussteil angreifen. Das dritte Anschlussteil entspricht hierbei also funktional dem aus EP 3 851 859 A1 bekannten Zwischenelement. Allerdings wird das dritte Anschlussteil bei dem erfindungsgemäßen Strommesswiderstand in dieser Variante nicht von dem zu messenden Strom durchflossen. Hier werden die Vorteile des Anschlussteils aus Leitermaterial für die Kontaktierung des Spannungsabgriffs genutzt und gleichzeitig die negativen Einflüsse des Leitermaterials auf die Spannungsmessung, wie der niedrige spezifische elektrische Widerstand und dessen hoher Temperaturkoeffizient, vermieden, da das dritte Anschlussteil nicht vom zu messenden Strom durchflossen wird.

Alternativ zu der vorstehend beschriebenen L-Form besteht auch die Möglichkeit, dass die beiden Schenkel des Strommesswiderstands einen anderen Winkel als 90° oder 180° einschließen. Allgemein können die beiden Schenkel des Strommesswiderstands beliebige Winkel zwischen 0° und 180° einschließen.

Die technische Realisierung der einzelnen Spannungsabgriffe und insbesondere des zweiten Spannungsabgriffs an einem der Widerstandselement oder an der Verbindung zwischen den beiden Widerstandselementen kann im Rahmen der Erfindung auf verschiedene Weise erfolgen. Beispielsweise kann hierzu ein Pin verwendet werden, der eingeprägt oder aufgeschweißt wird. Eine andere Möglichkeit der Verbindung ist eine Schweißverbindung mit einer Leiterkarte. Weiterhin besteht auch die Möglichkeit einer Press-Sinter-Verbindung (vgl. DE 10 2022 109 708.0) oder einer Lötverbindung mit einer Leiterkarte. Ferner besteht auch die Möglichkeit der technischen Realisierung der Spannungsabgriffe mittels einer Bond-Verbindung mit einem Draht. Die Erfindung ist jedoch hinsichtlich der technischen Realisierung der einzelnen Spannungsabgriffe nicht auf die vorstehend beschriebenen Alternativen beschränkt.

Weiterhin ist allgemein zu erwähnen, dass es sich bei den Leitermaterialien der Anschlussteile um Kupfer, eine Kupferlegierung, Aluminium oder eine Aluminiumlegierung
Die Leitermaterialien sollten hierbei jeweils einen kleineren spezifischen elektrischen Widerstand haben als das erste bzw. zweite Widerstandsmaterial der Widerstandselemente.

Ferner ist zu bemerken, dass es sich bei dem ersten Leitermaterial und dem zweiten Leitermaterial vorzugsweise um dasselbe Leitermaterial handelt. Es besteht jedoch alternativ auch die Möglichkeit, dass für die beiden Anschlussteile unterschiedliche Leitermaterialien (z.B. Kupfer und Aluminium) zum Einsatz kommen.

Allgemein ist auch zu erwähnen, dass der Strommesswiderstand vorzugsweise niederohmig ist, insbesondere mit einem Widerstandswert von höchstens 500 mΩ, 200 mΩ, 100 mΩ, 10 mΩ, 1 mΩ, 500 µΩ, 250 µΩ, 100 µΩ oder 50 µΩ.

Die Widerstandsmaterialien der Widerstandselemente haben deshalb vorzugsweise einen spezifischen elektrischen Widerstand aufweist, der kleiner ist als 10⁻⁴ Ω·m, 2.10⁻⁵ Ω·m oder 2.10⁻⁶ Ω·m.

Das Leitermaterial der Anschlussteile hat dagegen vorzugsweise einen spezifischen elektrischen Widerstand, der kleiner ist als 10⁻⁵ Ω·m, 10⁻⁶ Ω·m oder 10⁻⁷ Ω·m.

Ferner ist zu bemerken, dass die Widerstandsmaterialien vorzugsweise einen spezifischen elektrischen Widerstand mit einem Temperaturkoeffizienten von weniger als 5·10 ⁴ K⁻¹, 2·10 ⁴ K⁻¹, 1·10⁻⁻⁴ K⁻⁻¹ oder 5·10⁻⁵ K⁻¹ haben.

Bei den Widerstandsmaterialien kann es sich beispielsweise um eine Kupferlegierung handeln, z.B. eine Kupfer-Mangan-Nickel-Legierung, insbesondere Cu84Ni4Mn12. Alternativ besteht die Möglichkeit, dass es sich bei den Widerstandsmaterialien um eine Nickellegierung handelt, insbesondere NiCr oder CuNi.

Vorstehend wurde bereits erwähnt, dass die Anschlussteile und/oder die Widerstandselemente plattenförmig sein können. Herbei besteht die Möglichkeit, dass die plattenförmigen Anschlussteile bzw. die plattenförmigen Widerstandselemente jeweils eben oder gebogen sind.

Ferner ist auch zu erwähnen, dass die plattenförmigen Widerstandselemente vorzugsweise eine geringere Dicke haben als die ebenfalls plattenförmigen Anschlussteile. Dies ist vorteilhaft für eine Montage des Strommesswiderstands auf einer Leiterplatte (PCB: Printed Circuit Board) und auch beim Löten.

Vorstehend wurde der erfindungsgemäße Strommesswiderstand als einzelnes Bauteil beschrieben. Die Erfindung beansprucht jedoch auch Schutz für eine Strommessschaltung mit einem solchen Strommesswiderstand und einer Messschaltung zur Spannungsmessung an den einzelnen Spannungsabgriffen des Strommesswiderstands. Die Messschaltung weist deshalb vorzugsweise mehrere Messkanäle auf, um zwischen den Spannungsabgriffen an dem Strommesswiderstand mehrere verschiedene Spannungen messen zu können.

Ein erster Messkanal der Messschaltung dient vorzugsweise zur Spannungsmessung zwischen dem ersten Spannungsabgriff und dem zweiten Spannungsabgriff, während ein zweiter Messkanal zur Spannungsmessung zwischen dem zweiten Spannungsabgriff und dem dritten Spannungsabgriff dient.

In einer anderen Erfindungsvariante dient ein erster Messkanal zur Spannungsmessung zwischen dem ersten Spannungsabgriff und dem zweiten Spannungsabgriff, während ein zweiter Messkanal zur Spannungsmessung zwischen dem ersten Spannungsabgriff und dem dritten Spannungsabgriff dient.

Eine andere Erfindungsvariante sieht dagegen vor, dass ein erster Messkanal zur Spannungsmessung zwischen dem zweiten Spannungsabgriff und dem dritten Spannungsabgriff dient, während ein zweiter Messkanal zur Spannungsmessung zwischen dem ersten Spannungsabgriff und dem dritten Spannungsabgriff dient.

Bei den vorstehend beschriebenen Erfindungsvarianten weist die Messschaltung zwei Messkanäle auf. Es besteht jedoch im Rahmen der Erfindung auch die Möglichkeit, dass die Messschaltung mehr als zwei Messkanäle aufweist, beispielsweise drei Messkanäle oder sogar vier Messkanäle

So kann der erste Messkanal zur Spannungsmessung zwischen dem ersten Spannungsabgriff und dem zweiten Spannungsabgriff dienen, während der zweite Messkanal zur Spannungsmessung zwischen dem zweiten Spannungsabgriff und dem dritten Spannungsabgriff dient, wohingegen der dritte Spannungsabgriff zur Spannungsmessung zwischen dem ersten Spannungsabgriff und dem dritten Spannungsabgriff dient. Die drei gemessenen Spannungen können hierbei an dem Strommesswiderstand eine geschlossene Masche bilden, so dass sich die drei gemessenen Spannungen gemäß dem zweiten Kirchhoffschen Gesetz (Maschensatz) zu Null addieren müssen, sofern die Messung fehlerfrei ist. Bei einem Messfehler tritt jedoch eine Abweichung von null auf, was eine Fehlererkennung ermöglicht. Ein solcher Dreipunktabgriff ist an sich bereits aus DE 10 2021 103 238 A1 bekannt, so dass der Inhalt dieser Patentanmeldung der vorliegenden Beschreibung in vollem Umfang zuzurechnen ist.

Bei vier Spannungsbegriffen an dem Strommesswiderstand kann die Messschaltung beispielsweise folgende Messkanäle aufweisen:
- Messkanal 1: Spannung zwischen dem ersten Spannungsabgriff und dem zweiten Spannungsabgriff,
- Messkanal 2: Spannung zwischen dem ersten Spannungsabgriff und dem dritten Spannungsabgriff,
- Messkanal 3: Spannung zwischen dem ersten Spannungsabgriff und dem vierten Spannungsabgriff,
- Messkanal 4: Spannung zwischen dem zweiten Spannungsabgriff und dem dritten Spannungsabgriff,
- Messkanal 5: Spannung zwischen dem zweiten Spannungsabgriff und dem vierten Spannungsabgriff, und/oder
- Messkanal 6: Spannung zwischen dem dritten Spannungsabgriff und dem vierten Spannungsabgriff.

Darüber hinaus umfasst die erfindungsgemäße Strommessschaltung vorzugsweise eine Auswertungseinheit, die aus der gemessenen Spannung gemäß dem Ohmschen Gesetz den zu messenden Strom berechnet, der durch den Strommesswiderstand fließt. Die Berechnung des durch den Stromesswiderstand fließenden Stroms erfolgt vorzugsweise aus der Spannung in dem dritten Messkanal zwischen dem ersten Spannungsabgriff und dem dritten Spannungsabgriff. Zur Berechnung des Stroms wird also vorzugsweise die Spannung herangezogen, die über beiden Widerstandselementen gemeinsam abfällt.

Darüber hinaus ermöglicht die Auswertungseinheit vorzugsweise auch eine Fehlererkennung. Hierzu wird nicht nur die Spannung gemessen, die über den beiden Widerstandselementen gemeinsam gemessen wird, sondern auch die beiden Spannungen, die über den beiden Widerstandselement jeweils einzeln abfallen. Aus diesen Spannungen kann dann ebenfalls der Strom berechnet werden, wobei die verschiedenen Ströme bei einer fehlerfreien Messung gleich sein müssen. Falls sich dagegen der Widerstandswert eines der Widerstandselemente beispielsweise aufgrund einer Langzeitdrift anders ändert als der Widerstandswert des anderen Widerstandselements, so führt dies zu einer Berechnung unterschiedlicher Stromwerte aus den gemessenen Spannungen an dem ersten Widerstandselement einerseits und an dem zweiten Widerstandselement andererseits. Bei einer solchen Abweichung kann dann ein Fehlersignal generiert werden, wenn die Abweichung einen bestimmten tolerierten Wert überschreitet.

Vorstehend wurden der erfindungsgemäße Strommesswiderstand als einzelnes Bauteil und die erfindungsgemäße Strommessschaltung mit einem solchen Strommesswiderstand beschrieben. Die Erfindung beansprucht jedoch auch Schutz für ein Betriebsverfahren für eine erfindungsgemäße Strommessschaltung. Die einzelnen Verfahrensschritte des erfindungsgemäßen Betriebsverfahrens ergeben sich bereits aus der vorstehenden Beschreibung der erfindungsgemäßen Strommessschaltung, so dass auf eine separate Beschreibung verzichtet werden kann.

Darüber hinaus beansprucht die Erfindung auch Schutz für ein neuartiges Herstellungsverfahren für den erfindungsgemäßen Strommesswiderstand. Bei dem erfindungsgemäßen Herstellungsverfahren werden die beiden Anschlussteile und die beiden Widerstandselemente bereitgestellt und dann miteinander verbunden. Im Gegensatz zu dem eingangs beschriebenen bekannten Strommesswiderstand gemäß EP 3 851 859 A1 werden die beiden Widerstandselemente hierbei jedoch nicht mittelbar über ein separates Zwischenelement miteinander verbunden, sondern direkt und unmittelbar, beispielsweise durch eine Schweißverbindung.

Die beiden Anschlussteile und die beiden Widerstandselemente können hierbei zunächst als langgestreckte einbahnige Materialbänder ("Mono-Bänder") bereitgestellt werden, die dann entlang ihrer Längskanten zu einem vierbahnigen Verbundmaterialband ("Quattro-Band") zusammengefügt werden, beispielsweise durch Zusammenschweißen. Das Zusammenschweißen derartiger Verbundmaterialbänder ist an sich bereits bekannt und beispielsweise in EP 0 605 800 A1 beschrieben. Vorzugsweise werden hierbei zunächst die Widerstandsbänder zu einem zweibahnigen Verbundmaterialband ("Bi-Band") zusammengeschweißt, wobei die Anschlussbänder dann an das so entstandene Verbundmaterialband angeschweißt werden.

In einer anderen Variante des erfindungsgemäßen Herstellungsverfahrens werden dagegen zunächst das erste Anschlussteil und das erste Widerstandselement als zwei einbahnige Materialbänder ("Mono-Bänder") bereitgestellt, die dann entlang ihrer Längskanten zu einem ersten zweibahnigen Verbundmaterialband ("Bi-Band") zusammengefügt werden, beispielsweise durch Schweißen. In gleicher Weise werden auch das zweite Anschlussteile und das zweite Widerstandselement als zwei einbahnige Materialbänder bereitgestellt, die entlang ihrer Längskanten zu einem zweiten zweibahnigen Verbundmaterialband ("Bi-Band") zusammengefügt werden, beispielsweise durch Schweißen. Die beiden zwei zweibahnigen Verbundmaterialbänder ("Bi-Bänder") werden dann jeweils zu ersten bzw. zweiten Zwischenprodukten vereinzelt, die jeweils ein Anschlussteil und ein Widerstandselement umfassen. Im nächsten Schritt wird dann jeweils ein erstes Zwischenprodukt mit jeweils einem zweiten Zwischenprodukt zu einem erfindungsgemäßen Strommesswiderstand zusammengefügt, beispielsweise durch Zusammenschweißen. Die Verbindung zwischen den beiden Zwischenprodukten erfolgt hierbei jeweils an den Widerstandselementen. Die Verbindung zwischen den beiden Zwischenprodukten kann hierbei planparallel überlappend durch Press-Sintern oder durch Hartlöten erfolgen, wohingegen die Zusammenfügung der Materialbänder zu dem Verbundmaterial vorzugsweise durch Schweißen erfolgt.

Im Rahmen der Erfindung ist jedoch auch eine andere Variante eines erfindungsgemäßen Herstellungsverfahrens möglich. Dabei werden die beiden Anschlussteile und die beiden Widerstandselemente jeweils als vier lang gestreckte einbahnige Materialbänder ("Mono-Bänder") bereitgestellt.

Die einzelnen Materialbänder werden dann jeweils zu zahlreichen Anschlussteilen bzw. Widerstandselement vereinzelt. Im nächsten Schritt werden dann die vereinzelten Anschlussteile mit den vereinzelten Widerstandselementen zu dem erfindungsgemäßen Strommesswiderstand zusammengefügt setzt, beispielsweise durch Press-Sintern oder durch Löten. Diese Variante der Erfindung eignet sich insbesondere dann, wenn die verschiedenen Teile (Anschlussteile und Widerstandselemente) planparallel überlappen zusammengefügt werden sollen.

Andere vorteilhafte Weiterbildungen der Erfindung sind in den Unteransprüchen gekennzeichnet oder werden nachstehend zusammen mit der Beschreibung der bevorzugten Ausführungsbeispiele der Erfindung anhand der Figuren näher erläutert.

### Kurzbeschreibung der Zeichnungen

Figur 1A zeigt eine Perspektivansicht eines erfindungsgemäßen Strommesswiderstands mit zwei Widerstandselementen und drei Spannungsabgriffen, wobei der zweite Spannungsabgriff einen realen Mittelabgriff bildet.
Figur 1B zeigt eine Aufsicht auf den Strommesswiderstand gemäß Figur 1A.
Figuren 2A und 2B zeigen eine Abwandlung der Figuren 1A und 1B mit einem virtuellen Mittelabgriff und einem Stromschatten.
Figur 3A zeigt eine Perspektivansicht einer Abwandlung mit überlappenden Widerstandselementen.
Figur 3B zeigt eine Schnittansicht des Strommesswiderstands gemäß Figur 3A.
Figur 4A zeigt eine Perspektivansicht eines weiteren Ausführungsbeispiels eines erfindungsgemäßen Strommesswiderstands.
Figur 4B zeigt eine Aufsicht auf den Strommesswiderstand gemäß Figur 4A.
Figur 4C zeigt eine Seitenansicht des Strommesswiderstands gemäß den Figuren 4A und 4B.
Figuren 5A und 5B zeigen eine Perspektivansicht bzw. eine Seitenansicht eines weiteren Ausführungsbeispiels eines erfindungsgemäßen Strommesswiderstands.
Figur 6 zeigt eine Abwandlung von Figur 2B, wobei der zweite Spannungsabgriff als virtueller Mittelabgriff an dem anderen Anschlussteil angeordnet ist.
Figur 7 zeigt eine Abwandlung von Figur 6 mit vier Spannungsabgriffen.
Figur 8 zeigt eine Abwandlung von Figur 7.
Figur 9 zeigt eine Schnittansicht durch einen erfindungsgemäßen Strommesswiderstand.
Figur 10 zeigt eine Abwandlung von Figur 3B, wobei auch die Anschlussteile und die Widerstandselemente planparallel überlappen.
Figur 11 zeigt eine erfindungsgemäße Strommessschaltung mit dem erfindungsgemäßen Strommesswiderstand und einer Messschaltung.
Figuren 12-14 zeigen Abwandlungen eines erfindungsgemäßen Strommesswiderstands mit mittig angeordneten Stromschatten.
Figur 15 zeigt ein Flussdiagramm zur Verdeutlichung des erfindungsgemäßen Betriebsverfahrens für die Strommessschaltung.
Figur 16 zeigt ein Flussdiagramm zur Verdeutlichung einer Variante des erfindungsgemäßen Herstellungsverfahrens.
Figur 17 zeigt ein Flussdiagramm zur Verdeutlichung einer weiteren Variante des erfindungsgemäßen Herstellungsverfahrens.
Figur 18 zeigt ein Flussdiagramm zur Verdeutlichung einer dritten Variante des erfindungsgemäßen Herstellungsverfahrens.

### Detaillierte Beschreibung der Zeichnungen

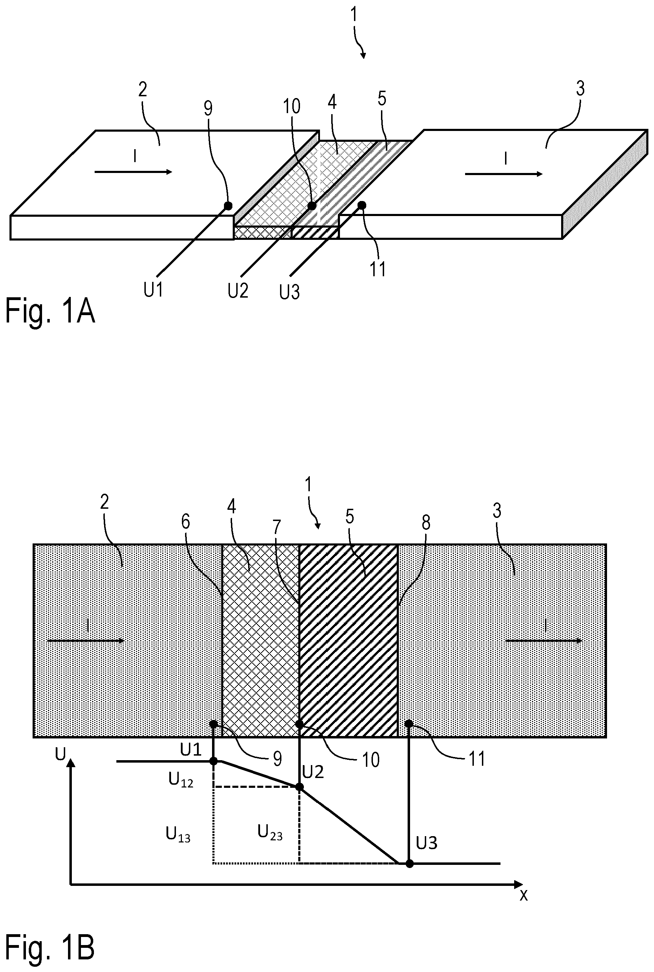

Im Folgenden wird zunächst das in den Figuren 1A und 1B dargestellte Ausführungsbeispiel eines erfindungsgemäßen Strommesswiderstands 1 beschrieben.

Der Strommesswiderstand 1 weist zunächst ein plattenförmiges Anschlussteil 2 aus einem Leitermaterial (z.B. Kupfer) auf, das dazu dient, einen zu messenden elektrischen Strom I in den Strommesswiderstand 1 einzuleiten.

Darüber hinaus weist der erfindungsgemäße Strommesswiderstand 1 in Übereinstimmung mit den bekannten Strommesswiderständen ein plattenförmiges Anschlussteil 3 aus einem Leitermaterial (z.B. Kupfer) auf, um den zu messenden elektrischen Strom I wieder aus dem Strommesswiderstand 1 auszuleiten.

Zwischen den beiden Anschlussteilen 2, 3 sind zwei plattenförmige Widerstandselemente 4, 5 angeordnet, die elektrisch in Reihe geschaltet sind und somit im Betrieb beide von dem zu messenden elektrischen Strom I durchflossen werden.

Hierbei ist zu erwähnen, dass die beiden Widerstandselemente 4, 5 aus unterschiedlichen Widerstandsmaterialien bestehen, wodurch ein sogenannter Common Cause Failure (CCF) vermieden werden kann. Beispielsweise können die Widerstandsmaterialien der beiden Widerstandselemente 4, 5 eine unterschiedliche Langzeitdrift des Widerstandswerts aufweisen, was eine messtechnische Überprüfung der Langzeitdrift ermöglicht.

Das Anschlussteil 2 ist hierbei durch eine Schweißnaht 6 mit dem Widerstandselement 4 verbunden. In gleicher Weise ist das Widerstandselement 4 durch eine Schweißnaht 7 mit dem Widerstandselement 5 verbunden. Darüber hinaus ist auch das Widerstandselement 5 durch eine Schweißnaht 8 mit dem Anschlussteil 3 verbunden.

Weiterhin ist zu erwähnen, dass die beiden Widerstandselemente 4, 5 eine geringere Dicke haben als die beiden Anschlussteile 2, 3, was die Montage des Stromesswiderstands 1 auf einer Leiterplatte erleichtert.

Darüber hinaus weist der Stromesswiderstand 1 in diesem Ausführungsbeispiel drei Spannungsabgriffe 9, 10, 11 auf.

Der Spannungsabgriff 9 ist hierbei an dem Anschlussteil 2 nahe der Schweißnaht 6 angeordnet und misst ein elektrisches Potenzial U1 an dem Anschlussteil 2.

Der Spannungsabgriff 10 befindet sich an der Schweißnaht 7 zwischen den beiden Widerstandselementen 4, 5 und misst ein elektrisches Potenzial U2 zwischen den beiden Widerstandselementen 4, 5. Der Spannungsabgriff 10 bildet hierbei also einen realen Mittelabgriff zwischen den beiden Widerstandselementen 4, 5.

Der Spannungsabgriff 11 ist dagegen an dem Anschlussteil 3 nahe der Schweißnaht 8 angeordnet und misst ein Potenzial U3 in dem Anschlussteil 3.

An dem Strommesswiderstand 1 können also über die drei Spannungsabgriffen 9-11 drei Spannungen U₁₂, U₁₃ und U₂₃ gemessen werden, wobei die Spannungen U₁₂, U₁₃, U₂₃ eine geschlossene Masche bilden und sich deshalb gemäß dem zweiten Kirchhoffschen Gesetz zu Null addieren, falls die Messung korrekt ist.

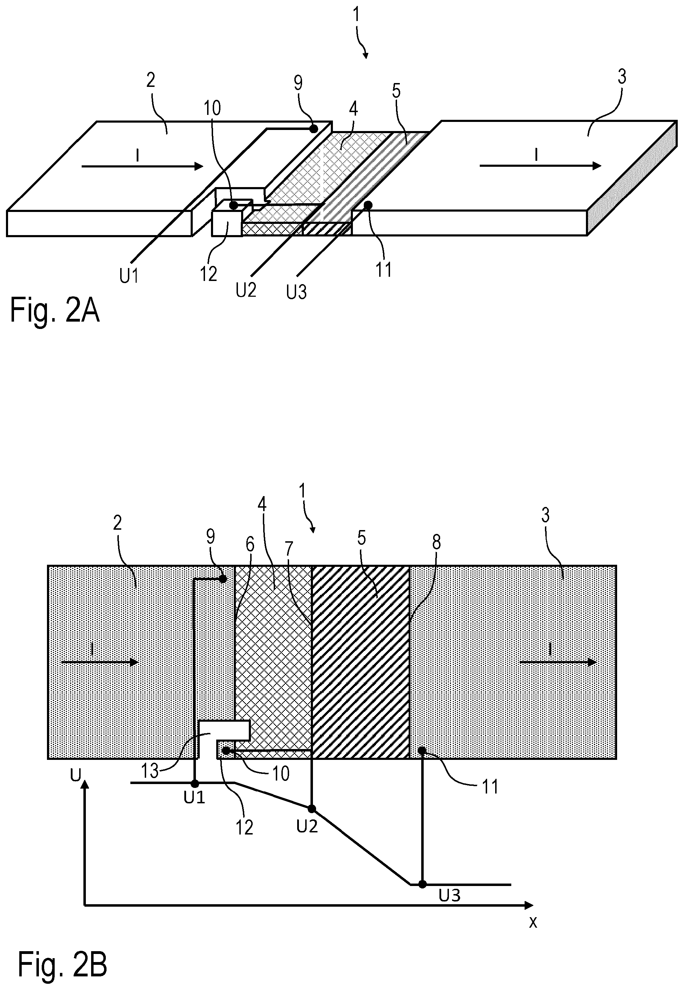

Die Figuren 2A und 2B zeigen ein abgewandeltes Ausführungsbeispiel, das weitgehend mit dem vorstehend beschriebenen und in den Figuren 1A und 1B dargestellten Ausführungsbeispiel übereinstimmt, so dass zur Vermeidung von Wiederholungen auf die vorstehende Beschreibung verwiesen wird, wobei für entsprechende Einzelheiten dieselben Bezugszeichen verwendet werden.

Eine Besonderheit dieses Ausführungsbeispiels besteht darin, dass anstelle des realen Mittelabgriffs ein virtueller Mittelabgriff vorgesehen ist. Der Spannungsabgriff 10 ist deshalb nicht an der Schweißnaht 7 zwischen den beiden Widerstandselement 4, 5 angeordnet, sondern an einer Kontaktinsel 12 in dem Anschlussteil 2. Der Spannungsabgriff 10 ist hierbei von einem Stromschatten 13 umgeben, der in dem Anschlussteil 2 die Kontaktinsel 12 für den Spannungsabgriff 10 abtrennt. Bei dem Stromschatten 13 handelte sich um einen L-förmigen Schlitz, der von einer Seitenkante des Strommesswiderstands 1 ausgeht und bis in das Widerstandselement 4 hineinragt. Dadurch erzwingt der Stromschatten 13 einen Stromfluss durch das Widerstandselement 4. Die Aufgabe des Stromschattens 13 besteht darin, die Feldlinien so zu verändern, dass das elektrische Potenzial an dem Spannungsabgriff 10 dem elektrischen Potenzial zwischen den beiden Widerstandselement 4, 5 entspricht. Der Spannungsabgriff 10 bildet hierbei also einen virtuellen Mittelabgriff.

Eine weitere Besonderheit dieses Ausführungsbeispiels besteht darin, dass der Spannungsabgriff 9 einerseits und der Spannungsabgriff 10 andererseits auf gegenüberliegenden Seiten des Strommesswiderstands 1 angeordnet sind.

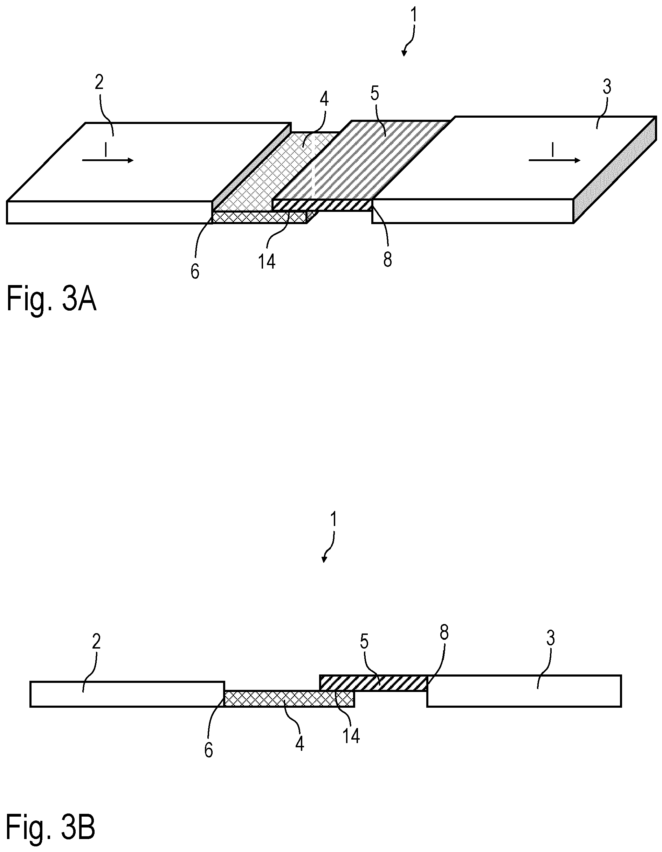

Die Figuren 3A und 3B zeigen ein abgewandeltes Ausführungsbeispiel, das weitgehend mit den vorstehend beschriebenen Ausführungsbeispielen übereinstimmt, so dass zur Vermeidung von Wiederholungen auf die vorstehende Beschreibung verwiesen wird, wobei für entsprechende Einzelheiten dieselben Bezugszeichen verwendet werden.

Eine Besonderheit dieses Ausführungsbeispiels besteht darin, dass die beiden Widerstandselemente 4, 5 hierbei nicht mit ihren Seitenkanten aneinanderstoßend verschweißt sind. Stattdessen überlappen die beiden Widerstandselemente 4, 5 hierbei planparallel, wobei die beiden Widerstandselemente 4, 5 in dem Überlappungsbereich durch eine Press-Sinter-Verbindung 14 miteinander verbunden sind.

Die Verbindung zwischen dem Anschlussteil 2 und dem Widerstandselement 4 sowie die Verbindung zwischen dem Widerstandselement 5 und dem Anschlussteil 3 erfolgt dagegen auch bei diesem Ausführungsbeispiel durch die Schweißnaht 6 bzw. 8.

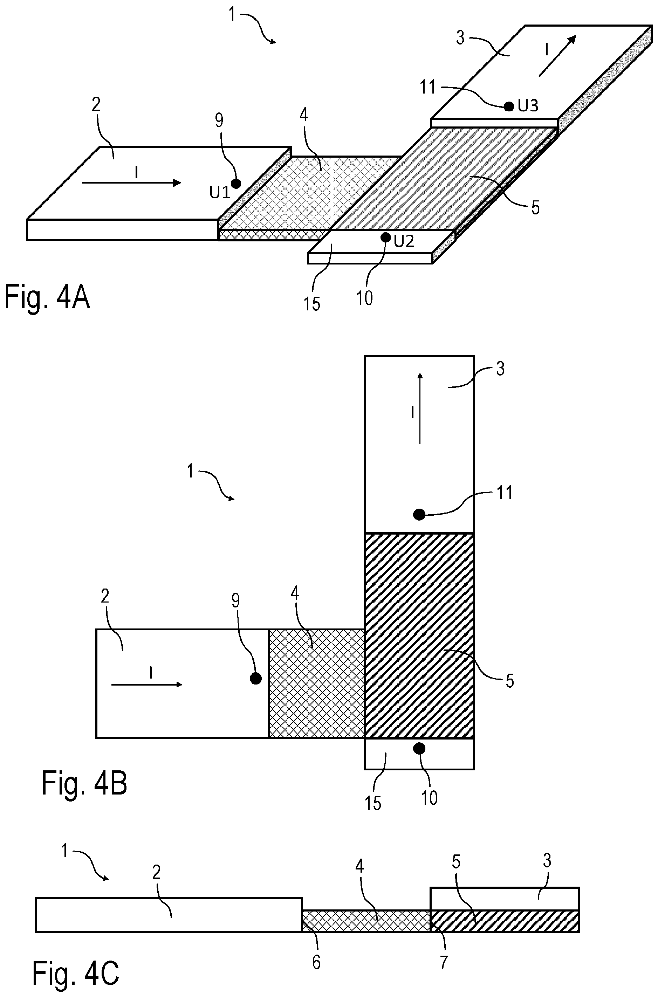

Die Figuren 4A-4C zeigen verschiedene Ansichten eines weiteren Ausführungsbeispiels eines erfindungsgemäßen Strommesswiderstands 1, der weitgehend mit den vorstehend beschriebenen Ausführungsbeispielen übereinstimmt, so dass zur Vermeidung von Wiederholungen auf die vorstehende Beschreibung verwiesen wird, wobei für entsprechende Einzelheiten dieselben Bezugszeichen verwendet werden.

Eine Besonderheit dieses Ausführungsbeispiels besteht darin, dass der Strommesswiderstand 1 in einer Aufsicht gemäß Figur 4B im wesentlichen L-förmig ist und zwei Schenkel aufweist, die rechtwinklig zueinander ausgerichtet sind. Ein erster Schenkel enthält hierbei das Anschlussteil 2 und das Widerstandselement 4. Ein zweiter Schenkel enthält hierbei das Widerstandselement 5 und das Anschlussteil 3.

An die Seitenkante des Widerstandselements 5 ist hierbei ein weiteres Anschlussteil 15 angeschweißt, das den Spannungsabgriff 10 trägt.

Die Verbindung zwischen den verschiedenen Teilen des Strommesswiderstands 1 erfolgt hierbei jeweils durch Schweißnähte 6-8, wie es bereits vorstehend beschrieben wurde.

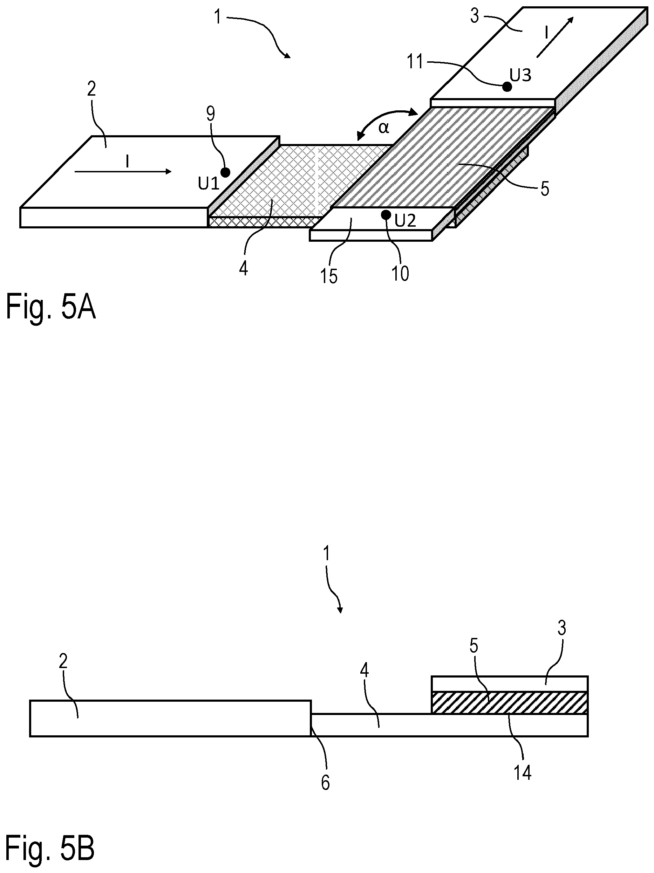

Die Figuren 5A und 5B zeigen eine Abwandlung des Ausführungsbeispiels gemäß den Figuren 4A-4C, so dass zur Vermeidung von Wiederholungen auf die vorstehende Beschreibung verwiesen wird, wobei für entsprechende Einzelheiten dieselben Bezugszeichen verwendet werden.

Eine Besonderheit dieses Ausführungsbeispiels besteht darin, dass die beiden Widerstandselemente 4, 5 nicht mit ihren Seitenkanten aneinander liegen, wie es bei dem Ausführungsbeispiel gemäß den Figuren 4A-4C der Fall ist. Vielmehr überlappen die beiden Widerstandselemente 4, 5 hierbei planparallel, wobei die beiden Widerstandselemente 4, 5 in dem Überlappungsbereich durch die Press-Sinter-Verbindung 14 miteinander verbunden sind, wie es bereits vorstehend beschrieben wurde.

Zwischen den beiden Schenkeln des Strommesswiderstands 1 liegt hierbei ein Winkel α=90°. Es sind jedoch in Abhängigkeit von den kundenseitigen Raumverhältnissen auch andere Winkel α möglich.

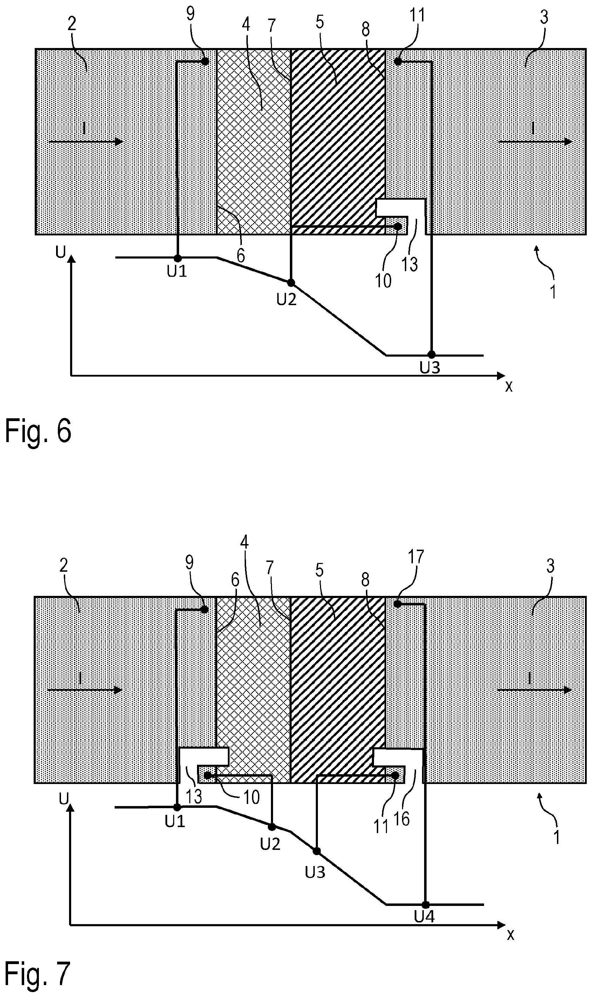

Das Ausführungsbeispiel gemäß Figur 6 stimmt weitgehend mit dem vorstehend beschriebenen und in den Figuren 2A und 2B dargestellten Ausführungsbeispiel überein, so dass zur Vermeidung von Wiederholungen auf die vorstehende Beschreibung verwiesen wird, wobei für entsprechende Einzelheiten dieselben Bezugszeichen verwendet werden.

Eine Besonderheit dieses Ausführungsbeispiels besteht darin, dass der Spannungsabgriff 10 hierbei nicht in dem Anschlussteil 2 angeordnet ist, sondern in dem anderen Anschlussteil 3. Entsprechend befindet sich auch der Stromschatten 13 in dem Anschlussteil 3 und trennt dort eine Kontaktinsel für den Spannungsabgriff 10 ab.

Das Ausführungsbeispiel gemäß Figur 7 kombiniert die beiden Varianten der Anordnung der Stromschatten 13 aus den Figuren 2A, 2B einerseits und Figur 6 andererseits.

So ist der dritte Spannungsabgriff 11 hierbei von einem weiteren Stromschatten 16 umgeben.

Darüber hinaus ist ein vierter Spannungsabgriff 17 an dem Anschlussteil 3 angeordnet, wobei der Spannungsabgriff 17 ein Potenzial U4 an dem Anschlussteil 3 misst.

Die beiden Spannungsabgriffe 11 und 17 sind hierbei in dem Strommesswiderstand 1 an gegenüberliegenden Längsseitenkanten des Stromesswiderstands 1 angeordnet.

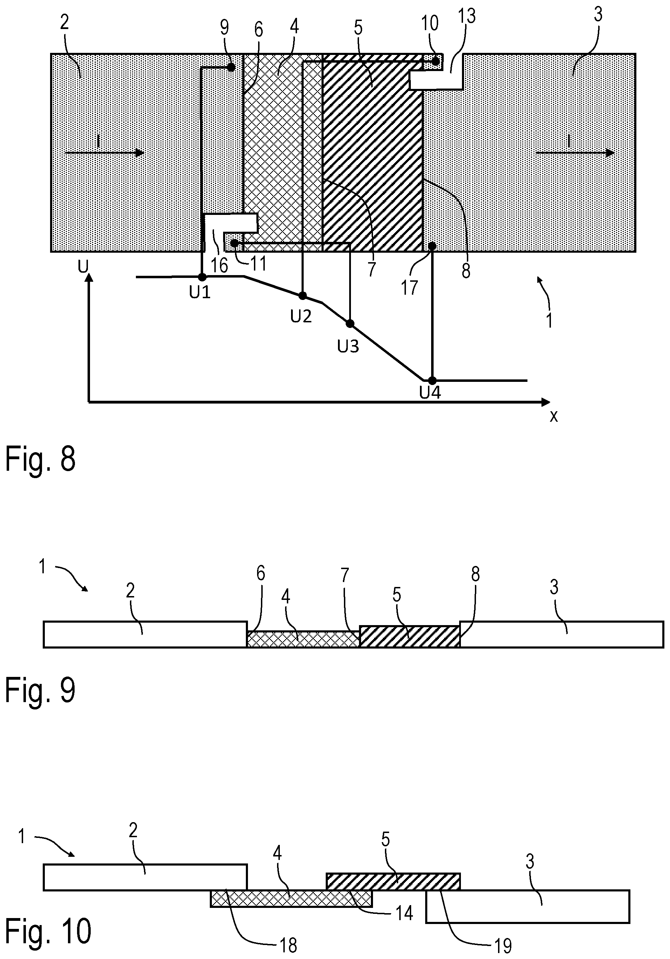

Das Ausführungsbeispiel gemäß Figur 8 stimmt weitgehend mit dem Ausführungsbeispiel gemäß Figur 7 überein, so dass zur Vermeidung von Wiederholungen auf die vorstehende Beschreibung verwiesen wird, wobei für entsprechende Einzelheiten dieselben Bezugszeichen verwendet werden.

Eine Besonderheit dieses Ausführungsbeispiels besteht darin, dass die beiden Stromschatten 13, 16 an gegenüberliegenden Längsseitenkanten des Strommesswiderstands 1 angeordnet sind.

Figur 9 zeigt eine Querschnittsansicht durch einen erfindungsgemäßen Strommesswiderstand 1, der ähnlich gemäß dem Strommesswiderstand gemäß den Figuren 1A und 1B aufgebaut ist, so dass zur Vermeidung von Wiederholungen auf die vorstehende Beschreibung verwiesen wird, wobei für entsprechende Einzelheiten dieselben Bezugszeichen verwendet werden.

Die Anschlussteile 2, 3 und die Widerstandselement 4, 5 sind hierbei jeweils plattenförmig und miteinander verschweißt.

Bei der Abwandlung gemäß Figur 10 erfolgt die Verbindung zwischen den einzelnen Teilen jeweils durch eine Press-Sinter-Verbindung.

So überlappt das plattenförmige Widerstandselement 4 planparallel mit dem ebenfalls plattenförmigen Widerstandselement 5 und ist im Überlappungsbereich durch die bereits vorstehend erwähnte Press-Sinter-Verbindung 14 mit dem Widerstandselement 5 verbunden.

Das plattenförmige Anschlussteil 2 überlappt ebenfalls planparallel mit dem plattenförmigen Widerstandselement 4 und ist im Überlappungsbereich durch eine weitere Press-Sinter-Verbindung 18 mit dem Widerstandselement 4 verbunden.

Das plattenförmige Widerstandselement 5 überlappt wiederum planparallel mit dem ebenfalls plattenförmigen Anschlussteil 3 und ist im Überlappungsbereich durch eine Press-Sinter-Verbindung 19 mit dem Anschlussteil 3 verbunden.

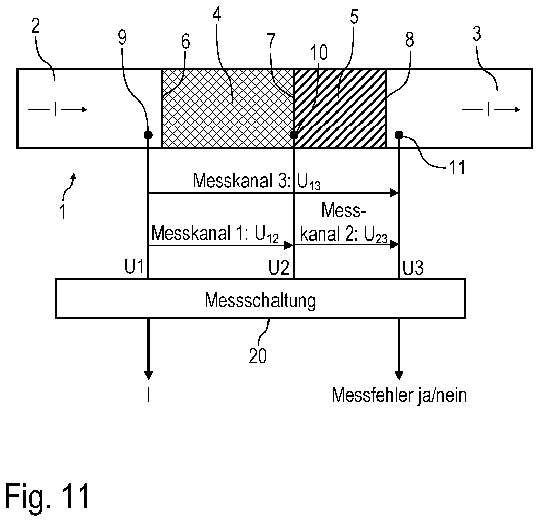

Figur 11 zeigte den erfindungsgemäßen Strommesswiderstand 1 als Bestandteil einer Strommessschaltung mit einer Messschaltung 20, die drei unabhängige Messkanäle aufweist.

In einem ersten Messkanal misst die Messschaltung 20 die Spannung U₁₂ zwischen den beiden Spannungsabgriffen 9 und 10.

In einem zweiten Messkanal misst die Messschaltung 20 dagegen die Spannung U₂₃ zwischen den beiden Spannungsabgriffen 10 und 11.

In einem dritten Messkanal misst die Messschaltung 20 dagegen die Spannung U₁₃ zwischen den beiden Spannungsabgriffen 9 und 11 an den beiden Anschlussteilen 2, 3.

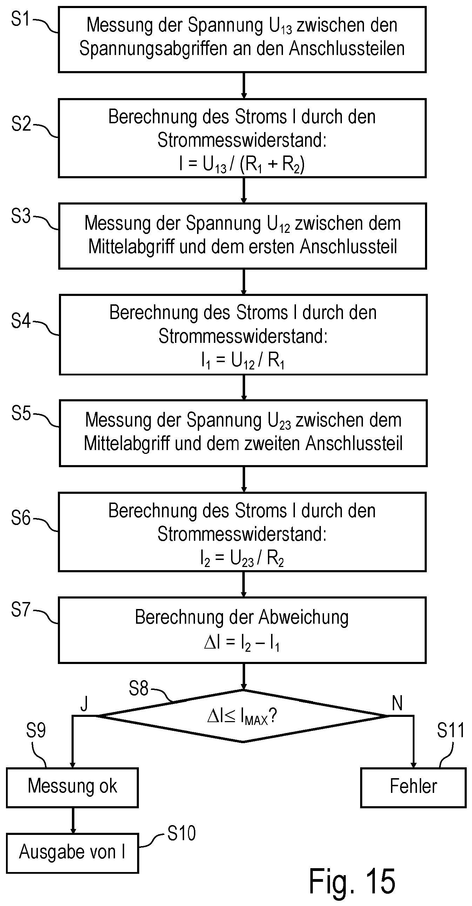

Die Funktionsweise der Messschaltung 20 wird später noch unter Bezugnahme auf das Flussdiagramm gemäß Figur 15 beschrieben.

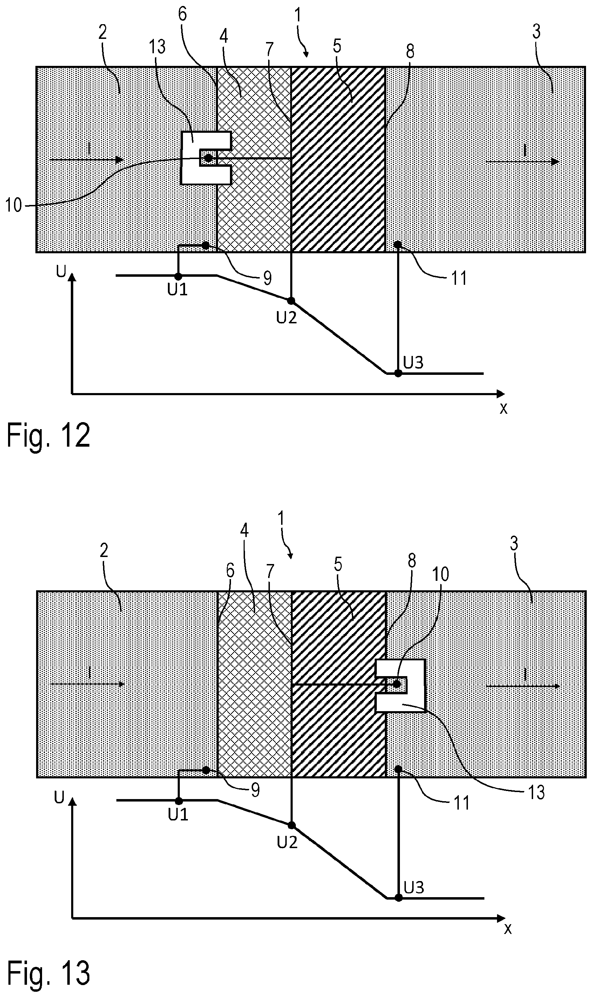

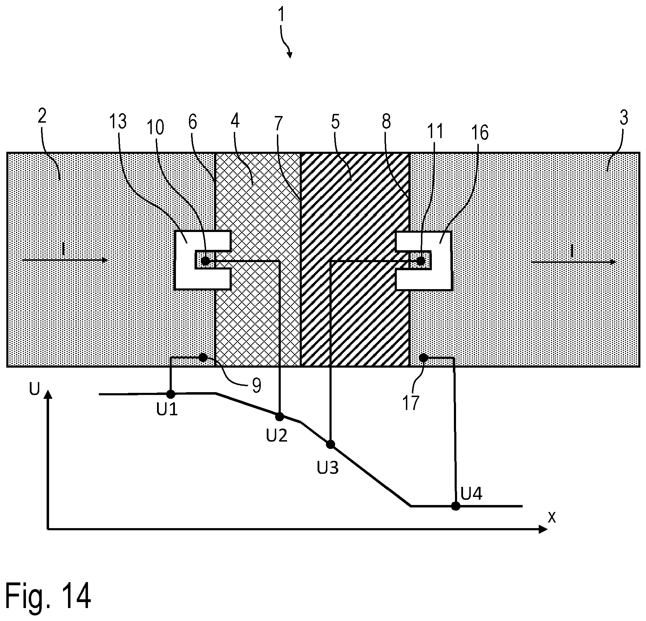

Die Figuren 12 bis 14 zeigen verschiedene abgewandelte Ausführungsbeispiele, die weitgehend mit den vorstehend beschriebenen Ausführungsbeispielen übereinstimmen, so dass zur Vermeidung von Wiederholungen auf die vorstehende Beschreibung verwiesen wird.

Eine Besonderheit dieser Ausführungsbeispiele besteht darin, dass die Stromschatten 13, 16 hierbei in dem Strommesswiderstand 1 mittig angeordnet sind.

Im Folgenden wird nun das Flussdiagramm gemäß Figur 15 beschrieben, das die Betriebsweise der Strommessschaltung gemäß Figur 11 verdeutlicht.

In einem ersten Schritt S1 wird zunächst die Spannung U₁₃ zwischen den Spannungsabgriffen 9, 11 an den beiden Anschlussteilen 2, 3 gemessen.

Im nächsten Schritt S2 wird dann aus der gemessenen Spannung U₁₃ entsprechend dem Ohmschen Gesetz der Strom I berechnet, der durch den Strommesswiderstand 1 fließt.

Im nächsten Schritt S3 wird dann die Spannung U₁₂ zwischen dem Spannungsabgriff 10 (realer Mittelabgriff) und dem Spannungsabgriff 9 an dem Anschlussteil 2 gemessen.

Im nächsten Schritt S4 wird dann wiederum ein Stromwert I₁ gemäß dem Ohmschen Gesetz aus der gemessenen Spannung U₁₂ berechnet.

In einem weiteren Schritt S5 wird dann die Spannung U₂₃ zwischen dem Spannungsabgriff 10 (realer Mittelabgriff) und dem Spannungsabgriff 11 an dem Anschlussteil 3 gemessen.

Der nächste Schritt S6 sieht dann wieder vor, dass der Strom I₂ gemäß dem Ohmschen Gesetz berechnet wird.

Bei einer fehlerfreien Messung müssen die beiden Stromwerte I₁ und I₂ gleich sein. Eine Abweichung zwischen den beiden Stromwerten I₁ und I₂ deutet dagegen auf einen Messfehler hin, beispielsweise aufgrund einer Langzeitdrift. In einem Schritt S7 wird dann die Abweichung ΔI zwischen den beiden Stromwerten I₁ und I₂ berechnet.

In einem folgenden Schritt S8 wird dann geprüft, ob die Abweichung ΔI einen vorgegebenen Maximalwert ΔI_{MAX} nicht überschreitet.

Falls dies der Fall ist, so wird in einem Schritt S9 davon ausgegangen, dass die Messung fehlerfrei ist und der in dem Schritt S2 berechnete Stromwert I wird in einem Schritt S10 ausgegeben.

Andernfalls wird dagegen in einem Schritt S11 ein Fehlersignal gesetzt.

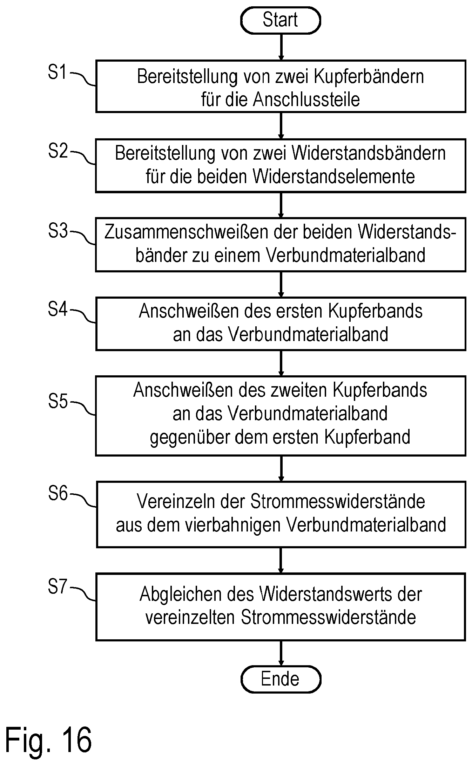

Im Folgenden wird nun das Flussdiagramm gemäß Figur 16 beschrieben, das eine erste Erfindungsvariante für die Herstellung des Stromesswiderstands 1 zeigt.

In einem ersten Schritt S1 werden zunächst zwei langgestreckte Kupferbänder für die beiden Anschlussteile 2, 3 bereitgestellt.

Darüber hinaus werden in einem Schritt S2 zwei langgestreckte Widerstandsbänder für die beiden Widerstandselemente 4, 5 bereitgestellt.

In einem Schritt S3 werden dann zunächst die beiden Widerstandsbänder zu einem zweibahnigen Verbundmaterialband ("Bi-Band") zusammengeschweißt.

In einem weiteren Schritt S4 wird dann das erste Kupferband an der einen Seite des Verbundmaterialbands angeschweißt.

Im nächsten Schritt S5 wird dann das zweite Kupferband auf der anderen Seite des Verbundmaterialbands angeschweißt.

Der nächste Schritt S6 sieht dann vor, dass aus dem auf diese Weise entstandenen vierbahnigen Verbundmaterialband die einzelnen Stromesswiderstände vereinzelt werden, beispielsweise durch Stanzen.

Im nächsten Schritt S7 kann dann noch ein Abgleich des Widerstandswerts der vereinzelten Strommesswiderstände erfolgen, beispielsweise durch das Einbringen von Trimmschnitten, wie es an sich aus dem Stand der Technik bekannt ist.

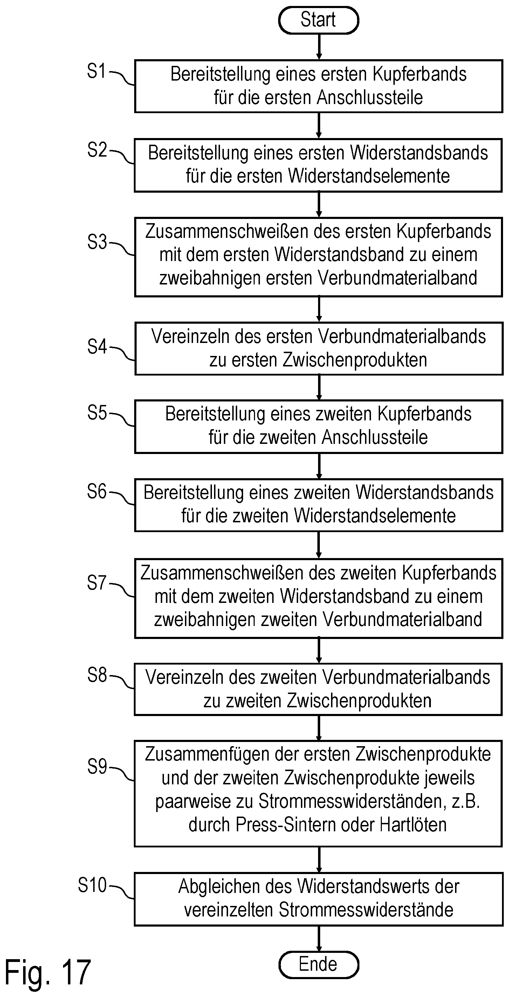

Im Folgenden wird nun das Flussdiagramm gemäß Figur 17 beschrieben, das eine zweite Erfindungsvariante zur Herstellung des erfindungsgemäßen Strommesswiderstands 1 verdeutlicht.

In einem ersten Schritt S1 wird zunächst ein erstes Kupferband für die ersten Anschlussteile 2 bereitgestellt.

In einem Schritt S2 wird ein erstes Widerstandsband für die ersten Widerstandselemente 4 bereitgestellt.

In einem Schritt S3 wird dann das erste Kupferband mit dem ersten Widerstandsband zu einem zweibahnigen ersten Verbundmaterialband ("Bi-Band") zusammengeschweißt, beispielsweise durch Elektronenstrahlschweißen.

Im nächsten Schritt S4 wird dann das so entstandene Verbundmaterialband zu ersten Zwischenprodukten vereinzelt, die jeweils eines der Anschlussteile 2 und eines der Widerstandselemente 4 enthalten.

In einem Schritt S5 wird dann ein zweites Kupferband für die zweiten Anschlussteile 3 bereitgestellt.

In einem Schritt S6 wird dann ein zweites Widerstandsband für die zweiten Widerstandselemente 5 bereitgestellt.

In einem Schritt S7 ist dann vorgesehen, dass das zweite Kupferband mit dem zweiten Widerstandsband zu einem weiteren zweibahnigen Verbundmaterialband ("Bi-Band") zusammengeschweißt wird.

Das so entstandene zweite Verbundmaterialband wird in einem Schritt S8 wieder zu zweiten Zwischenprodukten vereinzelt, die jeweils eines der Anschlussteile 3 und eines der Widerstandselemente 5 enthalten.

Im nächsten Schritt S9 werden die Zwischenprodukte dann jeweils paarweise zusammengefügt und zwar durch die bereits vorstehend beschriebene Press-Sinter-Verbindung 14.

Im nächsten Schritt S10 kann dann noch ein Abgleich des Widerstandswerts der vereinzelten Strommesswiderstände erfolgen, beispielsweise durch das Einbringen von Trimmschnitten, wie es an sich aus dem Stand der Technik bekannt ist.

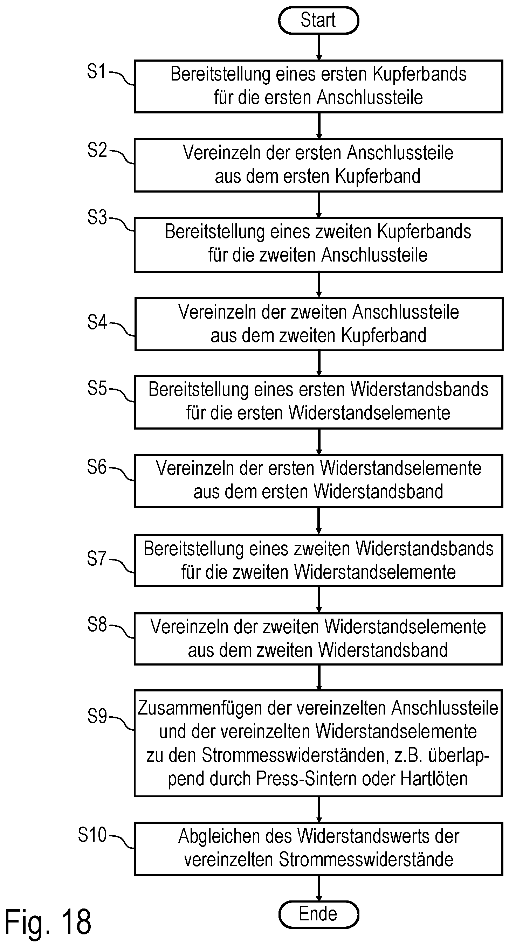

Im Folgenden wird nun das Flussdiagramm gemäß Figur 18 beschrieben, das eine weitere Erfindungsvariante zur Herstellung des erfindungsgemäßen Strommesswiderstands 1 verdeutlicht.

In einem ersten Schritt S1 wird zunächst ein erstes Kupferband für die ersten Anschlussteile 2 bereitgestellt.

Im zweiten Schritt S2 werden die Anschlussteile 2 dann aus dem ersten Kupferband vereinzelt, beispielsweise durch Stanzen.

In einem Schritt S3 wird dann ein zweites Kupferband für die zweiten Anschlussteile 3 bereitgestellt.

In einem Schritt S4 werden dann die zweiten Anschlussteile 3 von dem zweiten Kupferband vereinzelt.

Hierbei ist zu erwähnen, dass die Anschlussteile 2, 3 auch baugleich sein können und dann aus demselben Widerstandsmaterial bestehen. In diesem Fall kann auf die Schritte S3 und S4 verzichtet werden.

In einem weiteren Schritt S5 wird dann ein erstes Widerstandsband für die ersten Widerstandselemente 4 bereitgestellt.

Das erste Widerstandsband wird dann in dem Schritt S6 zu den ersten Widerstandselementen 4 vereinzelt, beispielsweise durch Stanzen.

In einem Schritt S7 wird dann ein zweites Widerstandsband bereitgestellt, aus dem die zweiten Widerstandselemente 5 hergestellt werden.

In einem Schritt S8 werden dann die zweiten Widerstandselemente 5 aus dem Widerstandsband vereinzelt, beispielsweise durch Stanzen.

In einem Schritt S9 werden dann die vereinzelten Teile (Anschlussteile 2, 3 und Widerstandselement 4, 5) zusammengefügt und zwar beispielsweise durch die vorstehend beschriebenen Press-Sinter-Verbindungen 14, 18, 19.

Im nächsten Schritt S10 kann dann noch ein Abgleich des Widerstandswerts der vereinzelten Strommesswiderstände 1 erfolgen, beispielsweise durch das Einbringen von Trimmschnitten, wie es an sich aus dem Stand der Technik bekannt ist.

### Vorteile der Erfindung

Die Erfindung ermöglicht die Erkennung von sogenannten Common Cause Failures (CCF), da in dem erfindungsgemäßen Strommesswiderstand verschiedene Widerstandselemente eingesetzt werden können, die unterschiedliche Materialeigenschaften haben können und deshalb auch ein unterschiedliches Fehlerverhalten (z.B. Langzeitdrift) zeigen.

Aufgrund der direkten und unmittelbaren Verbindung zwischen den beiden Widerstandselementen ist die Herstellung des erfindungsgemäßen Strommesswiderstands wesentlich einfacher als beim Stand der Technik. Weiterhin wird aufgrund der direkten und unmittelbaren Verbindung die Qualität der Strommessung in Bezug auf den Temperaturkoeffizienten des spezifischen elektrischen Widerstands im Vergleich zum Stand der Technik deutlich verbessert.

### Bezugszeichenliste

- 1: Strommesswiderstand
- 2: Anschlussteil zum Einleiten des Stroms in den Strommesswiderstand
- 3: Anschlussteil zum Ausleiten des Stroms aus dem Strommesswiderstand
- 4: Widerstandselement
- 5: Widerstandselement
- 6: Schweißnaht zwischen dem Anschlussteil zum Einleiten des Stroms und dem Widerstandselement
- 7: Schweißnaht zwischen den beiden Widerstandselementen
- 8: Schweißnaht zwischen dem Anschlussteil zum Ausleiten des Stroms und dem Widerstandselement
- 9: Erster Spannungsabgriff an dem Anschlussteil zum Einleiten des Stroms
- 10: Zweiter Spannungsabgriff an der Schweißnaht zwischen den beiden Widerstandselementen, an dem Anschlussteil zum Einleiten des Stroms oder an dem Anschlussteil zum Ausleiten des Stroms
- 11: Dritter Spannungsabgriff an dem Anschlussteil zum Ausleiten des Stroms oder an dem Anschlussteil zum Einleiten des Stroms
- 12: Kontaktinsel
- 13: Stromschatten (Schlitz) um den zweiten Spannungsabgriff
- 14: Press-Sinterverbindung zwischen den beiden Widerstandselementen
- 15: Anschlussteil an der Seite des Widerstandselements
- 16: Stromschatten (Schlitz) um den dritten Spannungsabgriff
- 17: Vierter Spannungsabgriff
- 18: Press-Sinter-Verbindung zwischen dem Anschlussteil und dem Widerstandselement
- 19: Press-Sinter-Verbindung zwischen dem Anschlussteil und dem Widerstandselement
- 20: Messschaltung
- I: Strom durch den Strommesswiderstand
- U1: Potential an dem ersten Spannungsabgriff
- U2: Potential an dem zweiten Spannungsabgriff
- U3: Potential an dem dritten Spannungsabgriff
- U4: Potential an dem vierten Spannungsabgriff
- U₁₂: Spannung in dem ersten Messkanal zwischen den ersten Spannungsabgriff und dem zweiten Spannungsabgriff
- U₂₃: Spannung in dem zweiten Messkanal zwischen den zweiten Spannungsabgriff und dem dritten Spannungsabgriff
- U₁₃: Spannung in dem dritten Messkanal zwischen den ersten Spannungsabgriff und dem dritten Spannungsabgriff
- I₁: Strom, der sich aus der Spannung U₁₂ über dem ersten Widerstandselement errechnet
- I₂: Strom, der sich aus der Spannung U₂₃ über dem zweiten Widerstandselement errechnet
- ΔI: Abweichung zwischen den Stromwerten I₁ und I₂
- ΔI_{MAX}: Maximal erlaubte Abweichung zwischen den Stromwerten I₁ und I₂
- R1: Widerstand des ersten Widerstandselements
- R2: Widerstand des zweiten Widerstandselements
- x: Weg in Stromflussrichtung entlang dem Strommesswiderstand
- U: Potential entlang dem Weg x

## Patentansprüche

1. Strommesswiderstand (1) zur Messung eines elektrischen Stroms (I), mit
a) einem ersten Anschlussteil (2) aus einem ersten Leitermaterial, insbesondere zum Einleiten des zu messenden Stroms (I) in den Strommesswiderstand (1),
b) einem zweiten Anschlussteil (3) aus einem zweiten Leitermaterial, insbesondere zum Ausleiten des zu messenden Stroms (I) aus dem Strommesswiderstand (1),
c) einem ersten Widerstandselement (4) aus einem ersten Widerstandsmaterial, und
d) einem zweiten Widerstandselement (5) aus einem zweiten Widerstandsmaterial,
e) wobei das erste Widerstandselement (4) und das zweite Widerstandselement (5) elektrisch in Reihe geschaltet zwischen dem ersten Anschlussteil (2) und dem zweiten Anschlussteil (3) angeordnet sind und im Betrieb beide von dem zu messenden Strom (I) durchflossen werden,
**gekennzeichnet durch**
f) eine direkte elektrische und mechanische Verbindung (7; 14) zwischen dem ersten Widerstandselement (4) und dem zweiten Widerstandselement (5).

2. Strommesswiderstand (1) nach Anspruch 1, **dadurch gekennzeichnet,**
a) **dass** das erste Widerstandselement (4) einen anderen elektrischen Widerstandswert hat als das zweite Widerstandselement (5), und/oder
b) **dass** sich das erste Widerstandsmaterial von dem zweiten Widerstandsmaterial unterscheidet und zwar vorzugsweise hinsichtlich
b1) des spezifischen elektrischen Widerstands,
b2) der Langzeitdrift des spezifischen elektrischen Widerstands,
b3) des Temperaturkoeffizienten des spezifischen elektrischen Widerstands, und/oder
b4) der Produktions-Charge, und/oder
c) **dass** das erste Widerstandselement (4) und das zweite Widerstandselement (5) unterschiedliche Widerstandswerte haben, aber aus demselben Widerstandsmaterial bestehen.
d) **dass** das erste Anschlussteil (2) und das erste Widerstandselement (4) beide plattenförmig sind und mit ihren Seitenkanten direkt aneinanderstoßen oder planparallel überlappen, und/oder
e) **dass** das erste Widerstandselement (4) und das zweite Widerstandselement (5) beide plattenförmig sind und mit ihren Seitenkanten direkt aneinanderstoßen oder planparallel überlappen, und/oder
f) **dass** das zweite Widerstandselement (5) und das zweite Anschlussteil (3) beide plattenförmig sind und mit ihren Seitenkanten direkt aneinanderstoßen oder planparallel überlappen,
g) **dass** das erste Widerstandselement (4) vorzugsweise auf der Unterseite oder an der Oberseite des ersten Anschlussteils (2) mit dem ersten Anschlussteil (2) planparallel überlappt, und
h) **dass** das zweite Widerstandselement (5) vorzugsweise auf der Oberseite oder an der Unterseite des zweiten Anschlussteils (3) mit dem zweiten Anschlussteil (3) planparallel überlappt, und
i) **dass** das erste Widerstandselement (4) vorzugsweise an der Unterseite oder an der Oberseite des zweiten Widerstandselements (5) mit dem zweiten Widerstandselement (5) planparallel überlappt.

3. Strommesswiderstand (1) nach einem der vorhergehenden Ansprüche, **dadurch gekennzeichnet,**
a) **dass** die Verbindung (7; 14) zwischen dem ersten Widerstandselement (4) und dem zweiten Widerstandselement (5) und/oder die Verbindung (6) zwischen dem ersten Anschlussteil (2) und dem ersten Widerstandselement (4) und/oder die Verbindung (8) zwischen dem zweiten Widerstandselement (5) und dem zweiten Anschlussteil (3) eine der folgenden Verbindungen ist:
a1) Schweißverbindung (6, 7, 8), insbesondere
a1.1) Elektronenstrahlschweißverbindung,
a1.2) Laserschweißverbindung,
a1.3) Widerstandsschweißverbindung oder
a1.4) Punktschweißverbindung,
a2) Pressverbindung, insbesondere Press-Sinterverbindung,
a3) Lötverbindung, insbesondere Hartlötverbindung oder Weichlötverbindung, und/oder
b) **dass** das erste Widerstandselement (4) in Stromflussrichtung die gleiche Länge hat wie das zweite Widerstandselement (5) oder eine andere Länge als das zweite Widerstandselement (5), und/oder
c) **dass** das erste Widerstandselement (4) quer zur Stromflussrichtung die gleiche Breite hat wie das zweite Widerstandselement (5) oder eine andere Breite als das zweite Widerstandselement (5), und/oder
d) **dass** das erste Widerstandselement (4) die gleiche Dicke hat wie das zweite Widerstandselement (5) oder eine andere Dicke als das zweite Widerstandselement (5).

4. Strommesswiderstand (1) nach einem der vorhergehenden Ansprüche,
**gekennzeichnet durch**
a) einen ersten Spannungsabgriff (9) an dem ersten Anschlussteil (2),
b) einen zweiten Spannungsabgriff (10)
b1) an dem ersten Widerstandselement (4), insbesondere als realer Mittelabgriff, oder
b2) an dem zweiten Widerstandselement (5), insbesondere als realer Mittelabgriff, oder
b3) an der Verbindung zwischen dem ersten Widerstandselement (4) und dem zweiten Widerstandselement (5), insbesondere als realer Mittelabgriff, oder
b4) an dem ersten Anschlussteil (2), insbesondere als virtueller Mittelabgriff oder
b5) an dem zweiten Anschlussteil (3), insbesondere als virtueller Mittelabgriff, und
c) einen dritten Spannungsabgriff (11) an dem ersten Anschlussteil (2) oder an dem zweiten Anschlussteil (3),
d) wobei optional der zweite Spannungsabgriff (10) an dem ersten Anschlussteil (2) angeordnet ist und teilweise von einem ersten Schlitz (13) an dem ersten Anschlussteil (2) umgeben ist, der einen Stromfluss quer über den ersten Schlitz (13) verhindert, oder der zweite Spannungsabgriff (10) an dem zweiten Anschlussteil (3) angeordnet ist und teilweise von einem ersten Schlitz (13) in dem zweiten Anschlussteil (3) umgeben ist, der einen Stromfluss quer über den ersten Schlitz (13) verhindert,
d) wobei optional der erste Spannungsabgriff (9) an dem ersten Anschlussteil (2) angeordnet ist, der zweite Spannungsabgriff (10) an dem ersten Anschlussteil (2) angeordnet ist, der zweite Spannungsabgriff (10) an dem ersten Anschlussteil (2) angeordnet ist und teilweise von einem ersten Schlitz (13) in dem ersten Anschlussteil (2) umgeben ist, der einen Stromfluss quer über den ersten Schlitz (13) verhindert, der dritte Spannungsabgriff (11) an dem zweiten Anschlussteil (3) angeordnet ist und teilweise von einem zweiten Schlitz (16) in dem zweiten Anschlussteil (3) umgeben ist, der einen Stromfluss quer über den zweiten Schlitz (16) verhindert, und optional ein vierter Spannungsabgriff (17) an dem zweiten Anschlussteil (3) angeordnet ist,
e) wobei optional der erste Spannungsabgriff (9) an dem ersten Anschlussteil (2) angeordnet ist, der zweite Spannungsabgriff (10) an dem zweiten Anschlussteil (3) angeordnet ist, der zweite Spannungsabgriff (10) an dem zweiten Anschlussteil (3) teilweise von einem ersten Schlitz (13) in dem zweiten Anschlussteil (3) umgeben ist, der einen Stromfluss quer über den ersten Schlitz (13) verhindert, und der dritte Spannungsabgriff (11) an dem ersten Anschlussteil (2) angeordnet ist und teilweise von einem zweiten Schlitz (16) in dem ersten Anschlussteil (2) umgeben ist, der einen Stromfluss quer über den zweiten Schlitz (16) verhindert, und optional ein vierter Spannungsabgriff an dem zweiten Anschlussteil (3) angeordnet ist,
f) wobei der zweite Spannungsabgriff (10) und der dritte Spannungsabgriff (11) beide an derselben Längskante des Strommesswiderstands (1) angeordnet sind, oder dass der zweite Spannungsabgriff (10) und der dritte Spannungsabgriff (11) an gegenüberliegenden Längskanten des Strommesswiderstands (1) angeordnet sind.

5. Strommesswiderstand (1) nach Anspruch 4, **dadurch gekennzeichnet,**
a) **dass** der erste Schlitz (13) von einer seitlichen Längskante des ersten Anschlussteils (2) ausgeht und sich bogenförmig, insbesondere L-förmig oder C-förmig, erstreckt
a1) bis vor die Verbindung mit dem ersten Widerstandselement (4),
a2) bis zu der Verbindung mit dem ersten Widerstandselement (4) oder
a3) bis in das erste Widerstandselement (4) hinein, und/oder
b) **dass** der zweite Schlitz (16) von einer seitlichen Längskante des zweiten Anschlussteils (3) ausgeht und sich bogenförmig, insbesondere L-förmig oder C-förmig, erstreckt
b1) bis vor die Verbindung mit dem zweiten Widerstandselement (5),
b2) bis zu der Verbindung mit dem zweiten Widerstandselement (5) oder
b3) bis in das zweite Widerstandselement (5) hinein, oder
c) **dass** der erste Schlitz (13) und/oder der zweite Schlitz (16) in dem Strommesswiderstand (1) mittig angeordnet ist.

6. Strommesswiderstand (1) nach einem der vorhergehenden Ansprüche,
**dadurch gekennzeichnet,**
a) **dass** das erste Widerstandselement (4) und das zweite Widerstandselement (5) beide plattenförmig sind,
b) **dass** an einer ersten Seitenkante des zweiten Widerstandselements (5) die Verbindung mit dem ersten Widerstandselement (4) angeordnet ist, und
c) **dass** an einer zweiten Seitenkante des zweiten Widerstandselements (5) ein plattenförmiges drittes Anschlussteil (15) aus einem Leitermaterial angebracht ist, insbesondere durch eine Schweißverbindung, wobei die erste Seitenkante und die zweite Seitenkante vorzugsweise unmittelbar aneinander angrenzen und rechtwinklig zueinander ausgerichtet sind,
d) **dass** der zweite Spannungsabgriff (10) an dem plattenförmigen dritten Anschlussteil (15) angeordnet ist, und
e) **dass** der Strommesswiderstand (1) in einer Aufsicht vorzugsweise L-förmig ist mit einem ersten Schenkel und einem zweiten Schenkel, wobei der erste Schenkel das erste Anschlussteil (2) und das erste Widerstandselement (4) umfasst, während der zweite Schenkel das zweite Widerstandselement (5) und das zweite Anschlussteil (3) umfasst.

7. Strommesswiderstand (1) nach einem der vorhergehenden Ansprüche,
**dadurch gekennzeichnet,**
a) **dass** das erste Anschlussteil (2), das erste Widerstandselement (4), das zweite Widerstandselement (5) und das zweite Anschlussteil (3) jeweils plattenförmig und parallel zueinander angeordnet sind,
b) **dass** der Strommesswiderstand (1) einen ersten Schenkel und einen zweiten Schenkel aufweist, die einen Winkel (α) einschließen,
c) **dass** der erste Schenkel des Strommesswiderstands (1) das erste Anschlussteil (2) und das erste Widerstandselement (4) enthält,
d) **dass** der zweite Schenkel des Strommesswiderstands (1) das zweite Anschlussteil (3) und das zweite Widerstandselement (5) enthält, und
e) **dass** der Winkel zwischen den beiden Schenkeln zwischen 0° und 180° liegt, insbesondere mit einem Winkel von 0°, 45°, 90°, 134° oder 180°.

8. Strommesswiderstand (1) nach einem der Ansprüche 4 bis 7, **dadurch gekennzeichnet,**
a) **dass** der zweite Spannungsabgriff (10) an dem ersten Widerstandselement (4) und/oder an dem zweiten Widerstandselement (5) angeordnet ist, und
b) **dass** der zweite Spannungsabgriff (10) wie folgt realisiert ist:
b1) durch einen Pin, der eingeprägt oder aufgeschweißt ist,
b2) durch eine Punktschweißverbindung mit einer Leiterkarte,
b3) durch eine Press-Sinter-Verbindung mit einer Leiterkarte,
b4) durch eine Lötverbindung mit einer Leiterkarte oder mit einem Kabel, oder
b5) durch eine Bond-Verbindung mit dem Draht.

9. Strommesswiderstand (1) nach einem der vorhergehenden Ansprüche,
**dadurch gekennzeichnet,**
a) **dass** das erste Leitermaterial und/oder das zweite Leitermaterial Kupfer, eine Kupferlegierung, Aluminium oder eine Aluminiumlegierung ist, und/oder
b) **dass** das erste Leitermaterial und das zweite Leitermaterial beide jeweils einen kleineren spezifischen elektrischen Widerstand haben als das erste Widerstandsmaterial und das zweite Widerstandsmaterial, und/oder
c) **dass** das erste Leitermaterial und das zweite Leitermaterial dasselbe Leitermaterial oder unterschiedliche Leitermaterialien sind, und/oder
d) **dass** der Strommesswiderstand (1) niederohmig ist, insbesondere mit einem Widerstandswert von höchstens 500 mΩ, 200 mΩ, 100 mΩ, 10 mΩ, 1 mΩ, 500 µΩ, 250 µΩ, 100 µΩ oder 50 µΩ, und/oder
e) **dass** das erste Widerstandsmaterial und/oder das zweite Widerstandsmaterial einen spezifischen elektrischen Widerstand aufweist, der kleiner ist als 10⁻⁴ Ω·m, 2.10⁻⁵ Ω·m oder 2.10⁻⁶ Ω·m, und/oder
f) **dass** das Leitermaterial einen spezifischen elektrischen Widerstand aufweist, der kleiner ist als 10⁻⁵ Ω·m, 10⁻⁶ Ω·m oder 10⁻⁷ Ω·m, und/oder
g) **dass** das erste Widerstandsmaterial und/oder das zweite Widerstandsmaterial einen spezifischen elektrischen Widerstand mit einem Temperaturkoeffizienten von weniger als 5.10⁻⁻⁴ K⁻¹, 2·10⁻⁴ K⁻¹, 1.10⁻⁴ K⁻¹ oder 5·10⁻⁵ K⁻¹ aufweist, und/oder
h) **dass** das erste Widerstandsmaterial
h1) eine Kupfer-Legierung ist, insbesondere eine Kupfer-Mangan-Legierung, insbesondere eine Kupfer-Mangan-Nickel-Legierung, insbesondere Cu84Ni4Mn12, oder
h2) eine Nickellegierung ist, insbesondere NiCr oder CuNi, und/oder
i) **dass** das erste Widerstandsmaterial und das das zweite Widerstandsmaterial das gleiche Material oder unterschiedliche Materialien sind, und/oder
j) **dass** das erste Anschlussteil (2) und/oder das zweite Anschlussteil (3) plattenförmig ist, und/oder
k) **dass** das erste Widerstandselement (4) und/oder das zweite Widerstandselement (5) plattenförmig ist, und/oder
l) dass die plattenförmigen Anschlussteile (2, 3) eben oder gebogen sind, und/oder
m) **dass** die plattenförmigen Widerstandselemente (4, 5) eben oder gebogen sind, und/oder
n) **dass** die beiden Widerstandselemente (4, 5) jeweils plattenförmig sind und eine geringere Dicke haben als die beiden plattenförmigen Anschlussteile (2, 3), und/oder
o) **dass** der Strommesswiderstand (1) ein SMD-Strommesswiderstand (1) ist, der für eine SMD-Montage ausgelegt ist, und/oder
p) **dass** das erste Anschlussteil (2) und/oder das zweite Anschlussteil (3) und/oder das erste Widerstandselement (4) und/oder das zweite Widerstandselement (5) jeweils quaderförmig sind.

10. Strommessschaltung mit
a) einem Strommesswiderstand (1) nach einem der vorhergehenden Ansprüche, und
b) einer Messschaltung mit mehreren Messkanälen zur Spannungsmessung an den Spannungsabgriffen des Strommesswiderstands (1).

11. Strommessschaltung nach Anspruch 10, **gekennzeichnet durch**
a) einen ersten Messkanal zur Spannungsmessung zwischen dem ersten Spannungsabgriff (9) und dem zweiten Spannungsabgriff (10) und einen zweiten Messkanal zur Spannungsmessung zwischen dem zweiten Spannungsabgriff (10) und dem dritten Spannungsabgriff (11), oder
einen ersten Messkanal zur Spannungsmessung zwischen dem ersten Spannungsabgriff (9) und dem zweiten Spannungsabgriff (10) und einen zweiten Messkanal zur Spannungsmessung zwischen dem ersten Spannungsabgriff (9) und dem dritten Spannungsabgriff (11), oder
einen ersten Messkanal zur Spannungsmessung zwischen dem zweiten Spannungsabgriff (10) und dem dritten Spannungsabgriff (11) und einen zweiten Messkanal zur Spannungsmessung zwischen dem ersten Spannungsabgriff (9) und dem dritten Spannungsabgriff (11), oder
einen ersten Messkanal zur Spannungsmessung zwischen dem ersten Spannungsabgriff (9) und dem zweiten Spannungsabgriff (10) und einen zweiten Messkanal zur Spannungsmessung zwischen dem zweiten Spannungsabgriff (10) und dem dritten Spannungsabgriff (11) und einen dritten Messkanal zur Spannungsmessung zwischen dem ersten Spannungsabgriff (9) und dem dritten Spannungsabgriff (11),
b) optional eine Auswertungseinheit, wobei die Auswertungseinheit aus der Spannung (U₁₃) in dem dritten Messkanal zwischen dem ersten Spannungsabgriff (9) und dem dritten Spannungsabgriff (11) gemäß dem ohmschen Gesetz den zu messenden Strom (I) berechnet, und zur Fehlererkennung aus der Spannung (U₁₂) in dem zweiten Messkanal und der Spannung (U₂₃) in dem dritten Messkanal jeweils gemäß dem Ohmschen Gesetz Stromwerte (I₁, I₂) berechnet und die beiden Stromwerte (I₁, I₂) miteinander vergleicht und eine Abweichung (ΔI) ermittelt, die auf einen Messfehler hindeutet.

12. Betriebsverfahren für eine Strommessschaltung gemäß einem der Ansprüche 10 bis 11, **gekennzeichnet durch** folgende Schritte:
a) Messen der Spannung (U₁₃) in dem dritten Messkanal zwischen ersten Spannungsabgriff (9) und dem dritten Spannungsabgriff (11), und Berechnen der **durch** den Strommesswiderstand (1) fließenden Stroms (I) gemäß dem ohmschen Gesetz aus der gemessenen Spannung(U₁₃) in dem dritten Messkanal zwischen ersten Spannungsabgriff (9) und dem dritten Spannungsabgriff (11), oder
b) Messen der Spannung (U₁₂) in dem ersten Messkanal zwischen dem ersten Spannungsabgriff (9) und dem zweiten Spannungsabgriff (10), und Berechnen eines ersten Stromwerts (I₁) gemäß dem ohmschen Gesetz aus der gemessenen Spannung (U₁₂) in dem ersten Messkanal, Messen der Spannung (U₂₃) in dem zweiten Messkanal zwischen dem zweiten Spannungsabgriff (10) und dem dritten Spannungsabgriff (11), und Berechnen eines zweiten Stromwerts (I₂) gemäß dem ohmschen Gesetz aus der gemessenen Spannung (U₂₃) in dem zweiten Messkanal, und Vergleichen der beiden Stromwerte (I₁, I₂) zur Erkennung eines Fehlers.

13. Herstellungsverfahren für einen Strommesswiderstand (1), insbesondere für einen Strommesswiderstand (1) nach einem der Ansprüche 1 bis 9, mit den folgenden Schritten:
a) Bereitstellung eines ersten Anschlussteils (2) aus einem ersten Leitermaterial, insbesondere zum Einleiten des zu messenden Stroms (I) in den Strommesswiderstand (1),
b) Bereitstellung eines zweiten Anschlussteils (3) aus einem zweiten Leitermaterial, insbesondere zum Ausleiten des zu messenden Stroms (I) aus dem Strommesswiderstand (1),
c) Bereitstellung eines ersten Widerstandselements (4) aus einem ersten Widerstandsmaterial,
d) Bereitstellung eines zweiten Widerstandselements (5) aus einem zweiten Widerstandsmaterial, und
e) Elektrisches und mechanisches Verbinden der Anschlussteile (2, 3) und der Widerstandselemente (4, 5),
**gekennzeichnet durch** folgenden Schritt:
f) Direktes elektrisches und mechanisches Verbinden des ersten Widerstandselements (4) mit dem zweiten Widerstandselement (5), so dass die beiden Widerstandselemente (4, 5) elektrisch in Reihe geschaltet zwischen dem ersten Anschlussteil (2) und dem zweiten Anschlussteil (3) angeordnet sind und im Betrieb beide von dem zu messenden Strom (I) durchflossen werden.

14. Herstellungsverfahren nach Anspruch 13, **dadurch gekennzeichnet,**
a) **dass** die Verbindung des ersten Widerstandselements (4) mit dem zweiten Widerstandselement (5) durch eines der folgenden Verfahren erfolgt:
a1) Schweißen, insbesondere
a1.1) Elektronenstrahlschweißen,
a1.2) Laserschweißen,
a1.3) Widerstandsschweißen oder
a1.4) Punktschweißen,
a2) Pressen, insbesondere Press-Sintern,
a3) Löten, insbesondere Hartlöten oder Weichlöten,
b) **dass** optional die beiden Anschlussteile (2, 3) und die beiden Widerstandselemente (4, 5) zunächst als langgestreckte einbahnige Materialbänder bereitgestellt werden, die dann entlang ihrer Längskanten zu einem vierbahnigen Verbundmaterialband zusammengefügt werden, insbesondere durch Zusammenschweißen, und dass die zusammengefügten vierbahnigen Verbundmaterialbänder zu den Strommesswiderständen vereinzelt werden, insbesondere durch Stanzen, und dass vorzugsweise zuerst die Materialbänder für die Widerstandselemente (4, 5) zu einem zweibahnigen Verbundmaterialband zusammengefügt werden und erst dann die Materialbänder für die Anschlussteile (2, 3) mit dem Verbundmaterialband zusammengefügt werden.

15. Herstellungsverfahren nach Anspruch 13 oder 14, **gekennzeichnet durch** folgende Schritte:
a) Bereitstellung des ersten Anschlussteils (2) und des ersten Widerstandselements (4) als zwei Materialbänder, die entlang ihrer Längskanten zu einem ersten Verbundmaterialband zusammengefügt werden, insbesondere **durch** Zusammenschweißen, Bereitstellung des zweiten Anschlussteils (3) und des zweiten Widerstandselements (5) als zwei Materialbänder, die entlang ihrer Längskanten zu einem zweiten Verbundmaterialband zusammengefügt werden, insbesondere **durch** Zusammenschweißen, Vereinzeln des ersten Verbundmaterialbands zu ersten Zwischenprodukten, Vereinzeln des zweiten Verbundmaterialbands zu zweiten Zwischenprodukten, und Zusammenfügen der ersten Zwischenprodukte und der zweiten Zwischenprodukte jeweils paarweise zu den Strommesswiderständen, insbesondere **durch** Press-Sintern oder **durch** Löten, oder
b) Bereitstellung der beiden Anschlussteile (2, 3) und der beiden Widerstandselemente (4, 5) als vier langgestreckte einbahnige Materialbänder, Vereinzeln der vier Materialbänder zu den beiden Anschlussteilen (2, 3) und den beiden Widerstandselementen (4, 5), und Verbinden der beiden Anschlussteile (2, 3) mit den beiden Widerstandselementen (4, 5) und Verbinden der beiden Widerstandselemente (4, 5) miteinander, insbesondere **durch** Press-Sintern oder **durch** Löten.

## Claims

1. Current measuring resistor (1) for measuring an electric current (I), comprising
a) a first connection part (2) made of a first conductor material, in particular for introducing the current (I) to be measured into the current-measuring resistor (1),
b) a second connection part (3) made of a second conductive material, in particular for leading the current (I) to be measured out of the current measuring resistor (1),
c) a first resistor element (4) made of a first resistive material, and
d) a second resistor element (5) made of a second resistive material,
e) wherein the first resistor element (4) and the second resistor element (5) are electrically connected in series between the first connection part (2) and the second connection part (3) and, during operation, are both traversed by the current (I) to be measured,
**characterized by**
f) a direct electrical and mechanical connection (7; 14) between the first resistor element (4) and the second resistor element (5).

2. Current measuring resistor (1) according to claim 1, **characterized in**
a) **that** the first resistor element (4) has a different electrical resistance value than the second resistor element (5), and/or
b) **that** the first resistive material differs from the second resistive material, preferably with respect to
b1) the specific electrical resistance,
b2) the long-term drift of the specific electrical resistance,
b3) the temperature coefficient of the specific electrical resistance, and/or
b4) the production batch, and/or
c) **that** the first resistor element (4) and the second resistor element (5) have different resistance values but are made of the same resistive material.
d) **that** the first connection part (2) and the first resistor element (4) are both plate-shaped and abut directly against each other with their side edges or overlap in a plane-parallel manner, and/or
e) **that** the first resistor element (4) and the second resistor element (5) are both plate-shaped and abut directly at their side edges or overlap in a plane-parallel manner, and/or
f) **that** the second resistor element (5) and the second connection part (3) are both plate-shaped and abut directly at their side edges or overlap in a plane-parallel manner,
g) **that** the first resistor element (4) preferably overlaps the first connection part (2) in a plane-parallel manner on the underside or on the top side of the first connection part (2), and
h) **that** the second resistor element (5) preferably overlaps the second connection part (3) in a plane-parallel manner on the top or bottom side of the second connection part (3), and
i) **that** the first resistor element (4) preferably overlaps the second resistor element (5) in a plane-parallel manner on the underside or on the top side of the second resistor element (5).

3. Current-measuring resistor (1) according to one of the preceding claims, **characterized in**
a) **that** the connection (7; 14) between the first resistor element (4) and the second resistor element (5) and/or the connection (6) between the first connection part (2) and the first resistor element (4) and/or the connection (8) between the second resistor element (5) and the second connection part (3) is one of the following connections:
a1) welded connection (6, 7, 8), in particular
a1.1) electron beam weld,
a1.2) laser welded joint,
a1.3) resistance welded joint or
a1.4) spot weld joint,
a2) pressed joint, in particular a pressed-sintered joint,
a3) soldered joint, in particular a brazed joint or a soldered joint, and/or
b) **that** the first resistor element (4) has the same length as the second resistor element (5) in the direction of current flow, or a different length than the second resistor element (5), and/or
c) **that** the first resistor element (4) has the same width as the second resistor element (5) or a different width than the second resistor element (5) in the direction transverse to the current flow, and/or
d) **that** the first resistor element (4) has the same thickness as the second resistor element (5) or a different thickness than the second resistor element (5).

4. Current measuring resistor (1) according to one of the preceding claims, **characterized by**
a) a first voltage tap (9) on the first connection part (2),
b) a second voltage tap (10)
b1) on the first resistor element (4), in particular as a real center tap, or
b2) on the second resistor element (5), in particular as a real center tap, or
b3) at the connection between the first resistor element (4) and the second resistor element (5), in particular as a real midpoint tap, or
b4) at the first connection part (2), in particular as a virtual center tap, or
b5) at the second connection part (3), in particular as a virtual center tap, and
c) a third voltage tap (11) on the first connection part (2) or on the second connection part (3),
d) wherein, optionally, the second voltage tap (10) is arranged on the first connection part (2) and is partially surrounded by a first slot (13) on the first connection part (2) that prevents current flow across the first slot (13), or the second voltage tap (10) is arranged on the second connection part (3) and is partially surrounded by a first slot (13) in the second connection part (3), which prevents current flow across the first slot (13),
d) wherein, optionally, the first voltage tap (9) is arranged on the first connection part (2), the second voltage tap (10) is arranged on the first connection part (2), the second voltage tap (10) is arranged on the first connection part (2) and is partially surrounded by a first slot (13) in the first connection part (2), which prevents current flow across the first slot (13), the third voltage tap (11) is arranged on the second connection part (3) and is partially surrounded by a second slot (16) in the second connection part (3), which prevents current flow across the second slot (16), and optionally, a fourth voltage tap (17) is arranged on the second connection part (3),
e) wherein, optionally, the first voltage tap (9) is arranged on the first connection part (2), the second voltage tap (10) is arranged on the second connection part (3), the second voltage tap (10) on the second connection part (3) is partially surrounded by a first slot (13) in the second connection part (3), which prevents current flow across the first slot (13), and the third voltage tap (11) is arranged on the first connection part (2) and is partially surrounded by a second slot (16) in the first connection part (2), which prevents current flow across the second slot (16), and optionally a fourth voltage tap is arranged on the second connection part (3),
f) wherein the second voltage tap (10) and the third voltage tap (11) are both arranged on the same longitudinal edge of the current-measuring resistor (1), or that the second voltage tap (10) and the third voltage tap (11) are arranged on opposite longitudinal edges of the current-measuring resistor (1).

5. Current-measuring resistor (1) according to claim 4, **characterized in**
a) **that** the first slot (13) extends from a lateral longitudinal edge of the first connection part (2) and extends in an arcuate shape, in particular L-shaped or C-shaped
a1) up to the point just before the connection with the first resistor element (4),
a2) up to the connection with the first resistor element (4), or
a3) into the first resistor element (4), and/or
b) **that** the second slot (16) extends from a lateral longitudinal edge of the second connection part (3) and extends in an arcuate shape, in particular an L-shape or a C-shape
b1) up to the point just before the connection with the second resistor element (5),
b2) up to the connection with the second resistor element (5), or
b3) into the second resistor element (5), or
c) **that** the first slot (13) and/or the second slot (16) is centrally arranged in the current-measuring resistor (1).

6. Current-measuring resistor (1) according to one of the preceding claims, **characterized in**
a) **that** the first resistor element (4) and the second resistor element (5) are both plate-shaped,
b) **that** the connection to the first resistor element (4) is located at a first side edge of the second resistor element (5), and
c) **that** a plate-shaped third connection part (15) made of a conductive material is attached to a second side edge of the second resistor element (5), in particular by a welded joint, wherein the first side edge and the second side edge preferably adjoin one another directly and are oriented at right angles to one another,
d) **that** the second voltage tap (10) is arranged on the plate-shaped third connection part (15), and
e) **that** the current measuring resistor (1) is preferably L-shaped in a top view, with a first leg and a second leg, wherein the first leg comprises the first connection part (2) and the first resistor element (4), while the second leg comprises the second resistor element (5) and the second connection part (3).

7. Current measuring resistor (1) according to one of the preceding claims, **characterized in**
a) **that** the first connection part (2), the first resistor element (4), the second resistor element (5), and the second connection part (3) are each plate-shaped and arranged parallel to one another,
b) **that** the current-measuring resistor (1) has a first leg and a second leg that form an angle (α),
c) **that** the first leg of the current-measuring resistor (1) contains the first connection part (2) and the first resistor element (4),
d) **that** the second leg of the current-measuring resistor (1) contains the second connection part (3) and the second resistor element (5), and
e) **that** the angle between the two legs is between 0° and 180°, in particular an angle of 0°, 45°, 90°, 134°, or 180°.

8. Current-measuring resistor (1) according to any one of claims 4 to 7, **characterized in**
a) **that** the second voltage tap (10) is arranged on the first resistor element (4) and/or on the second resistor element (5), and
b) **that** the second voltage tap (10) is implemented as follows:
b1) by a pin that is stamped or welded on,
b2) by a spot weld connection to a printed circuit board,
b3) by a press-sinter connection to a printed circuit board,
b4) by a soldered connection to a printed circuit board or to a cable, or
b5) by a bond connection to the wire.

9. Current-measuring resistor (1) according to one of the preceding claims, **characterized in**
a) **that** the first conductor material and/or the second conductor material is copper, a copper alloy, aluminum, or an aluminum alloy, and/or
b) **that** the first conductor material and the second conductor material each have a lower specific electrical resistance than the first resistive material and the second resistive material, and/or
c) **that** the first conductor material and the second conductor material are the same conductor material or different conductor materials, and/or
d) **that** the current-measuring resistor (1) is low-resistance, in particular having a resistance value of at most 500 mΩ, 200 mΩ, 100 mΩ, 10 mΩ, 1 mΩ, 500 µΩ, 250 µΩ, 100 µΩ or 50 µΩ, and/or
e) **that** the first resistive material and/or the second resistive material has a specific electrical resistance that is less than 10⁻⁴ Ω·m, 2.10⁻⁵ Ω·m or 2.10⁻⁶ Ω·m, and/or
f) **that** the conductor material has a specific electrical resistance that is less than 10⁻⁵ Ω·m, 10⁻⁶ Ω·m or 10⁻⁷ Ω·m, and/or
g) **that** the first resistive material and/or the second resistive material has a specific electrical resistance with a temperature coefficient of less than 5·10⁻⁴ K⁻¹, 2·10⁻⁴ K⁻¹, 1·10⁻⁴ K⁻¹, or 5·10⁻⁵ K⁻¹, and/or
h) **that** the first resistive material
h1) is a copper alloy, in particular a copper-manganese alloy, in particular a copper-manganese-nickel alloy, in particular Cu84Ni4Mn12, or
h2) a nickel alloy, in particular NiCr or CuNi, and/or
i) **that** the first resistive material and the second resistive material are the same material or different materials, and/or
j) **that** the first connection part (2) and/or the second connection part (3) is plate-shaped, and/or
k) **that** the first resistor element (4) and/or the second resistor element (5) is plate-shaped, and/or
l) **that** the plate-shaped connection parts (2, 3) are flat or curved, and/or
m) **that** the plate-shaped resistor elements (4, 5) are flat or curved, and/or
n) **that** the two resistor elements (4, 5) are each plate-shaped and have a smaller thickness than the two plate-shaped connection parts (2, 3), and/or
o) **that** the current-measuring resistor (1) is an SMD current-measuring resistor (1) designed for SMD mounting, and/or
p) **that** the first connection part (2) and/or the second connection part (3) and/or the first resistor element (4) and/or the second resistor element (5) are each cuboid in shape.

10. Current measurement circuit comprising
a) a current-measuring resistor (1) according to one of the preceding claims, and
b) a measuring circuit with multiple measuring channels for voltage measurement at the voltage taps of the current-measuring resistor (1).

11. Current measurement circuit according to claim 10, **characterized by**
a) a first measurement channel for measuring the voltage between the first voltage tap (9) and the second voltage tap (10) and a second measurement channel for measuring the voltage between the second voltage tap (10) and the third voltage tap (11), or
a first measurement channel for measuring the voltage between the first voltage tap (9) and the second voltage tap (10) and a second measurement channel for measuring the voltage between the first voltage tap (9) and the third voltage tap (11), or
a first measurement channel for measuring the voltage between the second voltage tap (10) and the third voltage tap (11) and a second measurement channel for measuring the voltage between the first voltage tap (9) and the third voltage tap (11), or
a first measurement channel for measuring the voltage between the first voltage tap (9) and the second voltage tap (10), a second measurement channel for measuring the voltage between the second voltage tap (10) and the third voltage tap (11), and a third measurement channel for measuring the voltage between the first voltage tap (9) and the third voltage tap (11),
b) optionally, an evaluation unit, wherein the evaluation unit calculates the current (I) to be measured from the voltage (U₁₃) in the third measurement channel between the first voltage tap (9) and the third voltage tap (11) in accordance with Ohm's law, and, for error detection, from the voltage (U₁₂) in the second measurement channel and the voltage (U₂₃) in the third measurement channel, respectively, in accordance with Ohm's law, and compares the two current values (I₁, I₂) with each other and determines a deviation (ΔI) that indicates a measurement error.

12. Operating method of a current measurement circuit according to one of claims 10 to 11, **characterized by** the following steps:
a) Measuring the voltage (U₁₃) in the third measurement channel between the first voltage tap (9) and the third voltage tap (11), and calculating the current (I) flowing through the current-measuring resistor (1) according to Ohm's law from the measured voltage (U₁₃) in the third measurement channel between the first voltage tap (9) and the third voltage tap (11), or
b) measuring the voltage (U₁₂) in the first measurement channel between the first voltage tap (9) and the second voltage tap (10), and calculating a first current value (I₁) according to Ohm's law from the measured voltage (U₁₂) in the first measurement channel, measuring the voltage (U₂₃) in the second measurement channel between the second voltage tap (10) and the third voltage tap (11), and calculating a second current value (I₂) according to Ohm's law from the measured voltage (U₂₃) in the second measurement channel, and comparing the two current values (I₁, I₂) to detect a fault.

13. Method of manufacturing a current-measuring resistor (1), in particular a current-measuring resistor (1) according to any one of claims 1 to 9, comprising the following steps:
a) providing a first connection part (2) made of a first conductor material, in particular for introducing the current (I) to be measured into the current-measuring resistor (1),
b) providing a second connection part (3) made of a second conductive material, in particular for discharging the current (I) to be measured from the current measuring resistor (1),
c) Providing a first resistor element (4) made of a first resistive material,
d) providing a second resistor element (5) made of a second resistive material, and
e) electrically and mechanically connecting the connection parts (2, 3) and the resistor elements (4, 5),
**characterized by** the following step:
f) Directly electrically and mechanically connecting the first resistor element (4) to the second resistor element (5) such that the two resistor elements (4, 5) are electrically connected in series between the first connection part (2) and the second connection part (3) and, during operation, both are traversed by the current (I) to be measured.

14. Method of manufacturing according to claim 13, **characterized in**
a) **that** the connection of the first resistor element (4) to the second resistor element (5) is made by one of the following methods:
a1) welding, in particular
a1.1) electron beam welding,
a1.2) Laser welding,
a1.3) Resistance welding, or
a1.4) Spot welding,
a2) pressing, in particular press sintering,
a3) brazing, in particular hard brazing or soft brazing,
b) **that**, optionally, the two connection parts (2, 3) and the two resistor elements (4, 5) are initially provided as elongated single-track material strips, which are then joined along their longitudinal edges to form a four-track composite material strip, in particular by welding, and that the joined four-track composite material strips are separated into the current-measuring resistors, in particular by punching, and that preferably the material strips for the resistor elements (4, 5) are joined together to form a two-track composite material strip, and only then are the material strips for the connection parts (2, 3) joined to the composite material strip.

15. Method of manufacturing according to claim 13 or 14, **characterized by** the following steps:
a) Providing the first connection part (2) and the first resistor element (4) as two material strips that are joined along their longitudinal edges to form a first composite material strip, in particular by welding, Providing the second connection part (3) and the second resistor element (5) as two material strips that are joined along their longitudinal edges to form a second composite material strip, in particular by welding, separating the first composite material strip into first intermediate products, separating the second composite material strip into second intermediate products, and joining the first intermediate products and the second intermediate products in pairs to form the current-measuring resistors, in particular by press sintering or by soldering, or
b) providing the two connection parts (2, 3) and the two resistor elements (4, 5) as four elongated single-layer material strips, separating the four material strips into the two connection parts (2, 3) and the two resistor elements (4, 5), and connecting the two connection parts (2, 3) to the two resistor elements (4, 5) and connecting the two resistor elements (4, 5) to each other, in particular by press sintering or by soldering.

## Revendications

1. Résistance de mesure de courant (1) destinée à mesurer un courant électrique (I), avec
a) une première partie de connexion (2) composée d'un premier matériau conducteur, destinée en particulier à introduire le courant électrique (I) à mesurer dans la résistance de mesure de courant (1),
b) une deuxième partie de connexion (3) composée d'un deuxième matériau conducteur, destinée en particulier à évacuer le courant électrique (I) à mesurer de la résistance de mesure de courant (1),
c) un premier élément de résistance (4) composé d'un premier matériau de résistance, et
d) un deuxième élément de résistance (5) composé d'un deuxième matériau de résistance,
e) dans laquelle le premier élément de résistance (4) et le deuxième élément de résistance (5) sont branchés en série électriquement entre la première partie de connexion (2) et la deuxième partie de connexion (3) et sont tous deux traversés par le courant (I) à mesurer lors du fonctionnement,
**caractérisée par**
f) une liaison électrique et mécanique directe (7 ; 14) entre le premier élément de résistance (4) et le deuxième élément de résistance (5).

2. Résistance de mesure de courant (1) selon la revendication 1, **caractérisée en ce**
a) **que** le premier élément de résistance (4) présente une valeur de résistance électrique différente de celle du deuxième élément de résistance (5), et/ou
b) **que** le premier matériau de résistance diffère du deuxième matériau de résistance et, à savoir de préférence en ce qui concerne
b1) la résistance électrique spécifique,
b2) la dérive à long terme de la résistance électrique spécifique,
b3) le coefficient de température de la résistance électrique spécifique, et/ou
b4)le lot de production, et/ou
c) **que** le premier élément de résistance (4) et le deuxième élément de résistance (5) ont des valeurs de résistance différentes, mais sont constitués du même matériau de résistance,
d) **que** la première partie de connexion (2) et le premier élément de résistance (4) sont tous deux en forme de plaque et butent directement l'un contre l'autre ou se chevauchent de manière plane et parallèle par leurs bords latéraux, et/ou
e) **que** le premier élément de résistance (4) et le deuxième élément de résistance (5) sont tous deux en forme de plaque et butent directement l'un contre l'autre ou se chevauchent de manière plane et parallèle par leurs bords latéraux, et/ou
f) **que** le deuxième élément de résistance (5) et la deuxième partie de connexion (3) sont tous deux en forme de plaque et butent directement l'un contre l'autre ou se chevauchent de manière plane et parallèle par leurs bords latéraux,
g) **que** le premier élément de résistance (4) chevauche de préférence sur la face inférieure ou sur la face supérieure de la première partie de connexion (2) la première partie de connexion (2) de manière plane et parallèle, et
h) **que** le deuxième élément de résistance (5) chevauche de préférence sur la face supérieure ou sur la face inférieure de la deuxième partie de connexion (3) la deuxième partie de connexion (3) de manière plane et parallèle, et
i) **que** le premier élément de résistance (4) chevauche de préférence sur la face inférieure ou sur la face supérieure du deuxième élément de résistance (5) le deuxième élément de résistance (5) de manière plane et parallèle.

3. Résistance de mesure de courant (1) selon l'une quelconque des revendications précédentes, **caractérisée en ce**
a) **que** la liaison (7 ; 14) entre le premier élément de résistance (4) et le deuxième élément de résistance (5) et/ou la liaison (6) entre la première partie de connexion (2) et le premier élément de résistance (4) et/ou la liaison (8) entre le deuxième élément de résistance (5) et la deuxième partie de connexion (3) est l'une des liaisons suivantes :
a1) liaison par soudage (6, 7, 8), en particulier
a1.1) liaison par soudage par faisceaux d'électrons,
al.2) liaison par soudage au laser,
al.3) liaison par soudage par résistance ou
al.4) liaison par soudage par points,
a2) liaison par pressage, en particulier liaison par pressage-frittage,
a3) liaison par brasage, en particulier liaison par brasage fort ou liaison par brasage tendre, et/ou
b) **que** le premier élément de résistance (4) a, dans la direction du flux de courant, la même longueur que le deuxième élément de résistance (5) ou une longueur différente de celle du deuxième élément de résistance (5), et/ou
c) **que** le premier élément de résistance (4) a transversalement à la direction de flux de courant la même largeur que le deuxième élément de résistance (5) ou une largeur différente de celle du deuxième élément de résistance (5), et/ou
d) **que** le premier élément de résistance (4) a la même épaisseur que le deuxième élément de résistance (5) ou une épaisseur différente de celle du deuxième élément de résistance (5).

4. Résistance de mesure de courant (1) selon l'une quelconque des revendications précédentes, **caractérisée par**
a) une première prise de tension (9) sur la première partie de connexion (2),
b) une deuxième prise de tension (10)
b1) sur le premier élément de résistance (4), en particulier en tant que prise centrale réelle, ou
b2) sur le deuxième élément de résistance (5), en particulier en tant que prise centrale réelle, ou
b3) sur la liaison entre le premier élément de résistance (4) et le deuxième élément de résistance (5), en particulier en tant que prise centrale réelle, ou
b4) sur la première partie de connexion (2), en particulier en tant que prise centrale virtuelle ou
b5) sur la deuxième partie de connexion (3), en particulier en tant que prise centrale virtuelle, et
c) une troisième prise de tension (11) sur la première partie de connexion (2) ou sur la deuxième partie de connexion (3),
d) dans laquelle, en option, la deuxième prise de tension (10) est disposée sur la première partie de connexion (2) et est entourée en partie d'une première fente (13) sur la première partie de connexion (2), qui empêche un flux de courant transversalement sur la première fente (13), ou la deuxième prise de tension (10) est disposée sur la deuxième partie de connexion (3) et est entourée en partie d'une première fente (13) dans la deuxième partie de connexion (3), qui empêche un flux de courant transversalement sur la première fente (13),
d) dans laquelle, en option, la première prise de tension (9) est disposée sur la première partie de connexion (2), la deuxième prise de tension (10) est disposée sur la première partie de connexion (2), la deuxième prise de tension (10) est disposée sur la première partie de connexion (2) et est entourée en partie d'une première fente (13) dans la première partie de connexion (2), qui empêche un flux de courant transversalement sur la première fente (13), la troisième prise de tension (11) est disposée sur la deuxième partie de connexion (3) et est entourée en partie d'une deuxième fente (16) dans la deuxième partie de connexion (3), qui empêche un flux de courant transversalement sur la deuxième fente (16), et en option une quatrième prise de tension (17) est disposée sur la deuxième partie de connexion (3),
e) dans laquelle, en option, la première prise de tension (9) est disposée sur la première partie de connexion (2), la deuxième prise de tension (10) est disposée sur la deuxième partie de connexion (3), la deuxième prise de tension (10) sur la deuxième partie de connexion (3) est entourée en partie d'une première fente (13) dans la deuxième partie de connexion (3), qui empêche un flux de courant transversalement sur la première fente (13), et la troisième prise de tension (11) est disposée sur la première partie de connexion (2) et est entourée en partie d'une deuxième fente (16) dans la première partie de connexion (2), qui empêche un flux de courant transversalement sur la deuxième fente (16), et en option une quatrième prise de tension est disposée sur la deuxième partie de connexion (3),
f) dans laquelle la deuxième prise de tension (10) et la troisième prise de tension (11) sont toutes deux disposées sur le même bord longitudinal de la résistance de mesure de courant (1), ou dans laquelle la deuxième prise de tension (10) et la troisième prise de tension (11) sont disposées sur des bords longitudinaux opposés de la résistance de mesure de courant (1).

5. Résistance de mesure de courant (1) selon la revendication 4, **caractérisée en ce**
a) **que** la première fente (13) part d'un bord longitudinal latéral de la première partie de connexion (2) et s'étend en forme d'arc, en particulier en forme de L ou de C,
al) jusqu'à devant la liaison au premier élément de résistance (4),
a2) jusqu'à la liaison au premier élément de résistance (4) ou
a3) jusque dans le premier élément de résistance (4), et/ou
b) **que** la deuxième fente (16) part d'un bord longitudinal latéral de la deuxième partie de connexion (3) et s'étend en forme d'arc, en particulier en forme de L ou de C,
b1) jusqu'à devant la liaison au deuxième élément de résistance (5),
b2) jusqu'à la liaison au deuxième élément de résistance (5) ou
b3) jusque dans le deuxième élément de résistance (5), ou
c) **que** la première fente (13) et/ou la deuxième fente (16) sont disposées au centre dans la résistance de mesure de courant (1).

6. Résistance de mesure de courant (1) selon l'une quelconque des revendications précédentes,
**caractérisée en ce**
a) **que** le premier élément de résistance (4) et le deuxième élément de résistance (5) sont tous deux en forme de plaque,
b) **que** la liaison au premier élément de résistance (4) est disposée sur un premier bord latéral du deuxième élément de résistance (5), et
c) **qu'**une troisième partie de connexion (15) en forme de plaque composée d'un matériau conducteur est installée sur un deuxième bord latéral du deuxième élément de résistance (5), en particulier par une liaison par soudage, dans laquelle le premier bord latéral et le deuxième bord latéral sont de préférence adjacents l'un à l'autre et sont orientés à angle droit l'un par rapport à l'autre,
d) **que** la deuxième prise de tension (10) est disposée sur la troisième partie de connexion (15) en forme de plaque, et
e) **que** la résistance de mesure de courant (1) est de préférence en forme de L dans une vue d'ensemble avec une première branche et une deuxième branche, dans laquelle la première branche comprend la première partie de connexion (2) et le premier élément de résistance (4), tandis que la deuxième branche comprend le deuxième élément de résistance (5) et la deuxième partie de connexion (3).

7. Résistance de mesure de courant (1) selon l'une quelconque des revendications précédentes,
**caractérisée en ce**
a) **que** la première partie de connexion (2), le premier élément de résistance (4), le deuxième élément de résistance (5) et la deuxième partie de connexion (3) sont disposés chacun en forme de plaque et parallèlement l'un à l'autre,
b) **que** la résistance de mesure de courant (1) présente une première branche et une deuxième branche, qui forment un angle (α),
c) **que** la première branche de la résistance de mesure de courant (1) contient la première partie de connexion (2) et le premier élément de résistance (4),
d) **que** la deuxième branche de la résistance de mesure de courant (1) contient la deuxième partie de connexion (3) et le deuxième élément de résistance (5), et
e) **que** l'angle entre les deux branches est compris entre 0° et 180°, en particulier avec un angle de 0°, 45°, 90°, 134° ou 180°.

8. Résistance de mesure de courant (1) selon l'une quelconque des revendications 4 à 7, **caractérisée en ce**
a) **que** la deuxième prise de tension (10) est disposée sur le premier élément de résistance (4) et/ou sur le deuxième élément de résistance (5), et
b) **que** la deuxième prise de tension (10) est réalisée comme suit :
b1) par une broche, qui est estampée ou soudée,
b2) par une liaison par soudage par points avec une carte à circuit imprimé,
b3) par une liaison de pressage-frittage avec une carte à circuit imprimé,
b4) par une liaison par brasage avec une carte à circuit imprimé ou avec un câble, ou
b5) par une liaison au fil.

9. Résistance de mesure de courant (1) selon l'une quelconque des revendications précédentes,
**caractérisée en ce**
a) **que** le premier matériau conducteur et/ou le deuxième matériau conducteur sont du cuivre, un alliage de cuivre, de l'aluminium ou un alliage d'aluminium, et/ou
b) **que** le premier matériau conducteur et le deuxième matériau conducteur ont chacun une résistance électrique spécifique inférieure à celle du premier matériau de résistance et du deuxième matériau de résistance, et/ou
c) **que** le premier matériau conducteur et le deuxième matériau conducteur sont le même matériau conducteur ou des matériaux conducteurs différents, et/ou
d) **que** la résistance de mesure du courant (1) est de faible impédance, en particulier avec une valeur de résistance d'au maximum 500 mΩ, 200 mΩ, 100 mΩ, 10 mΩ, 1 mΩ, 500 µΩ, 250 µΩ, 100 µΩ ou 50 µΩ, et/ou
e) **que** le premier matériau de résistance et/ou le deuxième matériau de résistance présentent une résistance électrique spécifique qui est inférieure à 10⁻⁴ Ω·m, 2·10⁻⁵ Ω·m ou 2·10⁻⁶ Ω·m, et/ou
f) **que** le matériau conducteur présente une résistance électrique spécifique qui est inférieure à 10⁻⁵ Ω·m, 10⁻⁶ Ω·m ou 10⁻⁷ Ω·m, et/ou
g) **que** le premier matériau de résistance et/ou le deuxième matériau de résistance présentent une résistance électrique spécifique avec un coefficient de température inférieur à 5·10⁻⁴ K⁻¹, 2·10⁻⁴ K⁻¹,1·10⁻⁴ K⁻¹ ou 5·10⁻⁵ K⁻¹, et/ou
h) **que** le premier matériau de résistance
h1) est un alliage de cuivre, en particulier un alliage de cuivre-manganèse, en particulier un alliage de cuivre-manganèse-nickel, en particulier Cu84Ni4Mn12, ou
c2) est un alliage de nickel, en particulier NiCr ou CuNi, et/ou
i) **que** le premier matériau de résistance et le deuxième matériau de résistance sont le même matériau ou des matériaux différents, et/ou
j) **que** la première partie de connexion (2) et/ou la deuxième partie de connexion (3) sont en forme de plaque, et/ou
k) **que** le premier élément de résistance (4) et/ou le deuxième élément de résistance (5) sont en forme de plaque, et/ou
l) que les parties de connexion (2, 3) en forme de plaque sont planes ou courbées, et/ou
m) **que** les éléments de résistance (4, 5) en forme de plaque sont plans ou courbés, et/ou
n) **que** les deux éléments de résistance (4, 5) sont chacun en forme de plaque et ont une épaisseur inférieure aux deux parties de connexion (2, 3) en forme de plaque, et/ou
o) **que** la résistance de mesure de courant (1) est une résistance de mesure de courant SMD (1), qui est conçue pour un montage SMD, et/ou
p) **que** la première partie de connexion (2) et/ou la deuxième partie de connexion (3) et/ou le premier élément de résistance (4) et/ou le deuxième élément de résistance (5) sont chacun de forme carrée.

10. Circuit de mesure du courant avec
a) une résistance de mesure de courant (1) selon l'une quelconque des revendications précédentes, et
b) un circuit de mesure avec plusieurs canaux de mesure pour la mesure de la tension sur les prises de tension de la résistance de mesure de courant (1).

11. Circuit de mesure de courant selon la revendication 10, **caractérisé par**
a) un premier canal de mesure pour la mesure de tension entre la première prise de tension (9) et la deuxième prise de tension (10) et un deuxième canal de mesure pour la mesure de tension entre la deuxième prise de tension (10) et la troisième prise de tension (11), ou
un premier canal de mesure pour la mesure de tension entre la première prise de tension (9) et la deuxième prise de tension (10) et un deuxième canal de mesure pour la mesure de tension entre la première prise de tension (9) et la troisième prise de tension (11), ou
un premier canal de mesure pour la mesure de tension entre la deuxième prise de tension (10) et la troisième prise de tension (11) et un deuxième canal de mesure pour la mesure de tension entre la première prise de tension (9) et la troisième prise de tension (11), ou
un premier canal de mesure pour la mesure de tension entre la première prise de tension (9) et la deuxième prise de tension (10) et un deuxième canal de mesure pour la mesure de tension entre la deuxième prise de tension (10) et la troisième prise de tension (11) et un troisième canal de mesure pour la mesure de tension entre la première prise de tension (9) et la troisième prise de tension (11),
b) en option une unité d'évaluation, dans lequel l'unité d'évaluation calcule le courant à mesurer (I) selon la loi d'Ohm à partir de la tension (U₁₃) dans le troisième canal de mesure entre la première prise de tension (9) et la troisième prise de tension (11) et calcule, pour la détection d'erreurs à partir de la tension (U₁₂) dans le deuxième canal de mesure et de la tension (U₂₃) dans le troisième canal de mesure, des valeurs de courant (I₁, I₂) respectivement selon la loi d'Ohm, et compare les deux valeurs de courant (I₁, I₂) entre elles et détermine un écart (ΔI), qui indique une erreur de mesure.

12. Procédé de fonctionnement pour un circuit de mesure de courant selon l'une des revendications 10 à 11, **caractérisé par** des étapes suivantes :
a) la mesure de la tension (U₁₃) dans le troisième canal de mesure entre la première prise de tension (9) et la troisième prise de tension (11), et le calcul du courant (I) traversant la résistance de mesure de courant (1) selon la loi d'Ohm à partir des tensions mesurées (U₁₃) dans le troisième canal de mesure entre la première prise de tension (9) et la troisième prise de tension (11), ou
b) la mesure de la tension (U₁₂) dans le premier canal de mesure entre la première prise de tension (9) et la deuxième prise de tension (10), et le calcul d'une première valeur de courant (I₁) selon la loi d'Ohm à partir de la tension mesurée (U₁₂) dans le premier canal de mesure, la mesure de la tension (U₂₃) dans le deuxième canal de mesure entre la deuxième prise de tension (10) et la troisième prise de tension (11), et le calcul d'une deuxième valeur de courant (I₂) selon la loi d'Ohm à partir de la tension mesurée (U₂₃) dans le deuxième canal de mesure, et la comparaison des deux valeurs de courant (I₁, I₂) pour détecter une erreur.

13. Procédé de fabrication d'une résistance de mesure de courant (1), en particulier d'une résistance de mesure de courant (1) selon l'une quelconque des revendications 1 à 9, avec les étapes suivantes :
a) la mise à disposition d'une première partie de connexion (2) composée d'un premier matériau conducteur, en particulier pour introduire le courant (I) à mesurer dans la résistance de mesure de courant (1),
b) la mise à disposition d'une deuxième partie de connexion (3) composée d'un deuxième matériau conducteur, en particulier pour évacuer le courant (I) à mesurer de la résistance de mesure de courant (1),
c) la mise à disposition d'un premier élément de résistance (4) composé d'un premier matériau de résistance,
d) la mise à disposition d'un deuxième élément de résistance (5) composé d'un deuxième matériau de résistance, et
e) la liaison électrique et mécanique des parties de connexion (2, 3) et des éléments de résistance (4, 5),
**caractérisé par** l'étape suivante :
f) la liaison électrique et mécanique directe du premier élément de résistance (4) au deuxième élément de résistance (5), de telle sorte que les deux éléments de résistance (4, 5) sont branchés électriquement en série entre la première partie de connexion (2) et la deuxième partie de connexion (3) et sont traversés tous deux, lors du fonctionnement, par le courant (I) à mesurer.

14. Procédé de fabrication selon la revendication 13, **caractérisé en ce**
a) **que** la liaison du premier élément de résistance (4) au deuxième élément de résistance (5) est effectuée par un des procédés suivants :
a1) soudage, en particulier
a1.1) soudage par faisceaux d'électrons,
a1.2) soudage par laser,
a1.3) soudage par résistance ou
a1.4) soudage par points,
a2) pressage, en particulier pressage-frittage,
a3) brasage, en particulier brasage fort ou brasage tendre,
b) **qu'**en option les deux parties de connexion (2, 3) et les deux éléments de résistance (4, 5) sont d'abord mis à disposition sous forme de bandes de matériau monovoies allongées qui sont ensuite assemblées le long de leurs bords longitudinaux en une bande de matériau composite à quatre voies, en particulier par assemblage par soudage, et que les bandes de matériau composite à quatre voies assemblées sont séparées des résistances de mesure de courant, en particulier par poinçonnage, et que, de préférence, les bandes de matériau pour les éléments de résistance (4, 5) sont d'abord assemblées pour former une bande de matériau composite à deux voies et que seulement alors les bandes de matériau pour les parties de connexion (2, 3) sont assemblées à la bande de matériau composite.

15. Procédé de fabrication selon la revendication 13 ou 14, **caractérisé par** des étapes suivantes :
a) la mise à disposition de la première partie de connexion (2) et du premier élément de résistance (4) sous forme de deux bandes de matériau, qui sont assemblées le long de leurs bords longitudinaux pour former une première bande de matériau composite, en particulier par assemblage par soudage, la mise à disposition de la deuxième partie de connexion (3) et du deuxième élément de résistance (5) sous forme de deux bandes de matériau, qui sont assemblées le long de leurs bords longitudinaux pour former une deuxième bande de matériau composite, en particulier par assemblage par soudage, la séparation de la première bande de matériau composite en des premiers produits intermédiaires, la séparation de la deuxième bande de matériau composite en des deuxièmes produits intermédiaires, et l'assemblage des premiers produits intermédiaires et des deuxièmes produits intermédiaires respectivement par paires pour former les résistances de mesure de courant, en particulier par pressage-frittage ou par brasage, ou
b) la mise à disposition des deux parties de connexion (2, 3) et des deux éléments de résistance (4, 5) sous forme de quatre bandes de matériau monovoies allongées, la séparation des quatre bandes de matériau pour former les deux parties de connexion (2, 3) et les deux éléments de résistance (4, 5), et la liaison des deux parties de connexion (2, 3) aux deux éléments de résistance (4, 5) et la liaison des deux éléments de résistance (4, 5) l'un à l'autre, en particulier par pressage-frittage ou par brasage.
